# EUROPEAN PATENT APPLICATION

(11) **EP 1 903 391 A2**
(43) Date of publication of application: **26.03.2008**
(21) Application number: 07017585.6
(22) Date of filing: 07.09.2007
(51) Int. Cl.: G03F 7/00, G03F 7/033

(54) **Composition for holographic recording medium, holographic recording medium, and method for producing the same**

(30) Priority: 20.09.2006 JP 2006254916
(71) Applicant: FUJIFILM Corporation, Minato-ku Tokyo (JP)
(72) Inventor: Matsumoto, Hirotaka, Asaka-shi Saitama (JP); Kamo, Makoto, Kaisei-machi Ashigarakami-gun Kanagawa (JP)
(74) Representative: HOFFMANN EITLE

(57) **Abstract**

The present invention aims to provide a composition for a holographic recording medium which allows for producing a disc medium filled with a photopolymer by a very simple method such as hot press method, with high dimensional precision, high uniformity and high productivity. The composition for a holographic recording medium contains a binder, a polymerizable polymer, and a photopolymerization initiator, wherein the binder is a polymer capable of forming a three-dimensional crosslinking structure by non-polymerization reaction. An aspect is preferable in which the polymer capable of forming a three-dimensional crosslinking structure by non-polymerization reaction is at least one of (A) a polymer which has an ionic group and formed a salt with the counterion of the ionic group and (B) a polymer having a crystal structure.

## Description

### BACKGROUND OF THE INVENTION

### Field of the Invention

The present invention relates to a composition for a holographic recording medium which allows for producing a disc medium filled with a photopolymer by a very simple method such as hot press method, with high dimensional precision, high uniformity and high productivity, and also relates to a holographic recording medium using the composition for a holographic recording medium and a method for producing the holographic recording medium.

### Description of the Related Art

As one of recording medium capable of writing a large volume of information such as high density image data, optical recording media are exemplified. For such optical recording media, although magneto optical discs, rewritable optical recording media such as phase change optical discs, and recordable optical recording media such as CD-R have been already put into practical use, demands for storing further large volume of data in an optical recording medium are more and more increasing. However, all the conventionally proposed optical recording media employ two-dimensional recording system, and there has been a limit in increasing recording capacity. The, recently, holographic optical recording media capable of recording information three-dimensionally such as discs and optical cards have become a focus of attention.

In a holographic recording medium, in general, an information beam given with a two-dimensional light intensity distribution is overlapped with a reference beam having substantially the same optical strength as that of the information beam in a photosensitive recording layer, and information is recorded by utilizing an interference pattern formed by interference between the information beam and the reference beam to induce a distribution of optical properties in the recording layer. In the meanwhile, when reading or reproducing the stored information, the recording layer is irradiated with only the reference beam with the same configuration at the time of recording, and the reference beam is emitted from the recording layer as a reproduction beam having an optical strength distribution corresponding to the optical property distribution formed in the recording layer.

In the holographic recording medium, a specific distribution of optical properties is three-dimensionally formed, and thus it is possible to partially overlap a region in which information is recorded with an information beam with another region in which information is recorded with another information beam, more specifically, multiple recording is enabled. When a digital volume holographic recording method is employed, signal to noise ratio (S/N) at a spot is extremely high, and thereby, even when the S/N ratio is rather reduced by multiple recording, the original information can be truly reproduced. As a result, the number of times of multiple recording can be extended to several hundreds times, and the recording capacity of the optical recording medium can be significantly increased (see Japanese Patent Application Laid-Open (JP-A) No. 2002-123949).

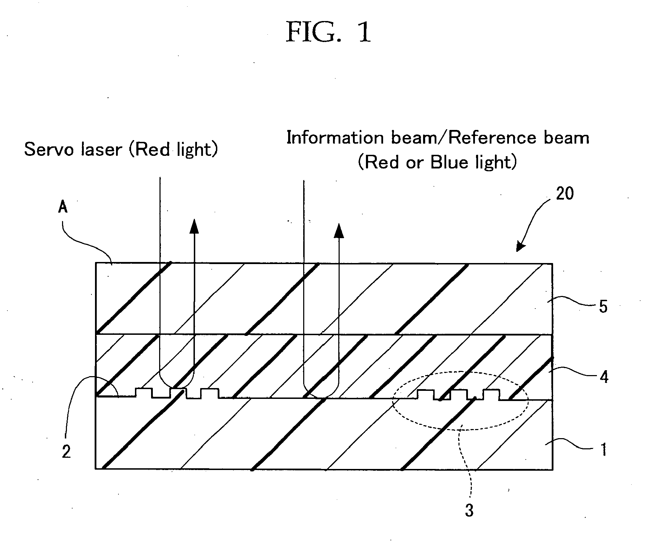

As such a holographic recording medium, for example, a holographic recording medium as shown in FIG. 1 is proposed in which a servo pit pattern 3 is formed on a surface of a under substrate 1, a reflection surface 2 composed of aluminum or the like is formed on the surface of the servo pit pattern 3, a recording layer 4 is formed on the reflection layer 2, and an upper substrate 5 is formed on the recording layer 4 (see Japanese Patent Application Laid-Open (JP-A) No.11-311936).

For a recording material of the recording layer, photopolymer is being studied as effective material for such application in view of its self-developing property and high-sensitivity.

As for a binder of the recording material, linear polymer such as polymethyl methacrylate can be used. However, use of such linear polymer actually causes a problem that formed images tend to blur with lapse of time, resulting in dropping out of the recording medium.

Then, to solve the problem, so called matrix, in which a three-dimensional crosslinking structure is formed, has become used as a binder.

As means to form the matrix, methods are proposed to induce crosslinking reaction by utilizing thermal reaction such as cationic polymerization of epoxy resins, stepwise polymerization between isocyanate and alcohol, stepwise polymerization of epoxy resin and mercaptan (see Japanese Patent Application Laid-Open (JP-A) Nos.11-352303 and 2004-287138).

However, when a thick layer having a thickness of around 100 µm to 2,000 µm is formed inside a disc or a card, reaction is induced with nonuniformity in in-plane and/or in the thickness direction, warpage and/or distortion are easily caused by shrinkage on curing accompanied by reaction, resulting in a low yield. Further, since a curing reaction should be performed in batch process, the productivity is low.

In the meanwhile, as a resin capable of forming a three-dimensional crosslinking structure by ionic bonding, instead of by polymerization reaction, ionomer resins are known (see Japanese Patent Application Laid-Open (JP-A) Nos. 2002-234975, 2003-82184, and "Ionomer Ionic Polymer Material" published by CMC Publishing Co., Ltd.). Further, similarly to the above, as a resin capable of forming a three-dimensional crosslinking structure by non-polymerization, an ethylene-acid copolymer resin is known in which a microscopic crystal of polyethylene initiates crosslinking reaction (see "Ionomer Ionic Polymer Material" published by CMC Publishing Co., Ltd.).

However, there is no embodiment proposed using these resins for holographic optical recording media.

Accordingly, a composition for a holographic recording medium which allows for producing a disc medium filled with a photopolymer by a very simple method such as hot press method realization of a disc medium of high productivity by photopolymer filling and very simple way of hot press, which high dimensional precision, high uniformity and high productivity, a holographic recording medium allowing for high density recording by using the composition for a holographic recording medium, and the production method of the holographic recording medium have not yet been provided so far. Thus, presently, further improvement and development are desired.

The present invention aims to solve the conventional problems and to achieve the following objects. Specifically, the present invention is to provide a composition for a holographic recording medium which allows for producing a disc medium filled with a photopolymer by a very simple method such as hot press method, with high dimensional precision, high uniformity and high productivity, a holographic recording medium using the composition for a holographic recording medium as well as a method for producing the holographic recording medium.

### BRIEF SUMMARY OF THE INVENTION

< 1 > A composition for a holographic recording medium containing a binder, a polymerizable polymer, and a photopolymerization initiator, wherein the binder is a polymer capable of forming a three-dimensional crosslinking structure by non-polymerization reaction.
< 2 > The composition for a holographic recording medium according to the item < 1 >, wherein the polymer capable of forming a three-dimensional crosslinking structure by non-polymerization reaction is at least one of (A) a polymer which has an ionic group and formed a salt with the counterion of the ionic group and (B) a polymer having a crystal structure.
< 3 > The composition for a holographic recording medium according to the item < 2 >, wherein (A) the polymer which has an ionic group and formed a salt with the counterion of the ionic group is an ionomer resin.
< 4 > The composition for a holographic recording medium according to the item < 3 >, wherein the ionomer resin is an ethylene ionomer resin.
< 5 > The composition for a holographic recording medium according to any one of the items < 2 > to < 4 >, wherein (B) the polymer having a crystal structure is an ethylene copolymer resin.
< 6 > The composition for a holographic recording medium according to the item < 5 >, wherein the ethylene copolymer resin is any one of an ethylene-carboxylic acid copolymer resin and an ethylene-vinyl acetate copolymer resin.
< 7 > The composition for a holographic recording medium according to any one of the items < 1 > to < 6 >, formed in a pellet shape.
< 8 > A holographic recording medium, having a substrate, a holographic recording layer which contains a composition for a holographic recording medium according to any one of the items < 1 > to < 7 >, and a wavelength selective reflection layer formed in between the substrate and the holographic recording layer.
<9 > The holographic recording medium according to the item < 8 >, wherein the substrate has a servo pit pattern.
< 10 > The holographic recording medium according to the item < 9 >, wherein the substrate further has a reflection surface on the surface of the servo pit pattern.
< 11 > The holographic recording medium according to the item < 8 >, wherein the wavelength selective reflection layer is a layer containing a dichroic mirror.
< 12 > The holographic recording medium according to any one of the items < 8 > to < 10 >, wherein the wavelength selective reflection layer is a layer containing a cholesteric liquid crystal.
< 13 > The holographic recording medium according to any one of the items < 10 > to < 12 >, further having a gap layer formed in between the wavelength selective reflection layer and the reflection surface, to smooth the substrate surface.
< 14 > The holographic recording medium according to any one of the items <12> to < 13 >, wherein the layer containing a cholesteric liquid crystal is a single layer, and contains at least one of a nematic liquid crystal compound and a photoreactive chiral compound.
< 15 > The holographic recording medium according to the item <14>, wherein the photoreactive chiral compound has a chiral site and a photoreactive group, and the chiral site is at least one selected from isosorbide compounds, isomanide compounds, and binaphthol compounds.
< 16 > The holographic recording medium according to the item <15>, wherein the photoreactive group is a group that induces isomerization of carbon-carbon double bond from trans to cis by light irradiation.
< 17 > The holographic recording medium according to any one of the items <12> to < 16 >, wherein the selective reflection wavelength band of the layer containing a cholesteric liquid crystal is continuous.
< 18 > The holographic recording medium according to any one of the items <12> to < 17 >, wherein the selective reflection wavelength band width of the layer containing a cholesteric liquid crystal is 100 nm or more.
< 19 > The holographic recording medium according to any one of the items < 8 > to < 18 >, wherein the wavelength selective reflection layer is transmissive to a light having a first wavelength and reflects a light having a second wavelength that differs from the light having the first wavelength.
< 20 > The holographic recording medium according to the item <19>, wherein the light having the first wavelength has a wavelength in the range of 350 nm to 600 nm, and the light of the second wavelength has a wavelength in the range of 600 nm to 900 nm.
< 21 > The holographic recording medium according to any one of the items <8> to < 20 >, wherein a light reflectance in the range of λ₀ to λ₀/cos20° is 40% or more, where λ₀ represents a wavelength of irradiation light.
< 22 > The holographic recording medium according to any one of the items <8> to < 21 >, wherein a light reflectance in the range of λ₀ to λ₀/cos40° is 40% or more where λ₀ represents a wavelength of irradiation light.
< 23 > The holographic recording medium according to the item <22>, wherein the reflection layer is a metal reflection layer.
< 24 > A method for producing a holographic recording medium which includes forming a holographic recording layer using a composition for a holographic recording medium according to any one of the items < 1 > to < 7 >, wherein the holographic recording medium comprises a substrate, a holographic recording layer in which information is holographically recorded, and a wavelength reflection layer formed between the substrate and the holographic recording layer.
< 25 > A holographic recording method which includes irradiating a holographic recording medium according to any one of the items < 8 > to < 23 > with an information beam and a reference beam as a coaxial luminous flux, and recording information on the recording layer based on an interference pattern that is formed by interference between the information beam and the reference beam.
<26> A holographic reproducing method which includes reproducing recorded information by irradiating an interference pattern that has been recorded on a holographic recording layer by a holographic recording method according to the item < 25 >

The composition for a holographic recording medium of the present invention contains a binder, a polymerizable monomer, and a photopolymerization initiator. Since a polymer capable of forming a three-dimensional crosslinking structure by non-polymerization reaction is used as the binder, it is possible to produce a disc medium filled with a photopolymer by a very simple method such as hot press method, with high dimensional precision, high uniformity and high productivity.

Since the holographic recording medium of the present invention has a holographic recording layer containing the composition for a holographic recording medium, it is possible to produce a disc medium filled with a photopolymer by a very simple method such as hot press method, with high dimensional precision, high uniformity and high productivity and to obtain a high density holographic recording medium.

The hologram recording method of the present invention enables to realize high density recording that has not been conventionally achieved by irradiating the holographic recording medium of the present invention with an information beam and a reference beam as a coaxial luminous flux and recording information on a holographic recording layer based on an interference pattern formed by interference between the information beam and the reference beam.

In the hologram reproducing method of the present invention, an interference pattern, which is recorded on a holographic recording layer of a holographic recording medium of the present invention using the composition for a holographic recording medium of the present invention, by the hologram recording method of the present invention, can be efficiently and accurately read to reproduce the recorded high density information.

### BRIEF DESCRIPTION OF THE SEVRAL VIEWS OF THE DRAWINGS

FIG.1 is a schematic cross-sectional view exemplarily showing a structure of a conventional holographic recording medium.
FIG. 2 is a graph showing reflection properties of a wavelength selective reflection layer of a holographic recording medium of the present invention to an incident light applied from 0° (at front side) to the wavelength selective reflection layer.
FIG. 3 is a graph showing reflection properties of a wavelength selective reflection layer of a holographic recording medium of the present invention to an incident light applied from an inclination angle of 40° to the wavelength selective reflection layer.
FIG. 4 is a graph showing reflection properties of a wavelength selective reflection layer of another holographic recording medium of the present invention to an incident light applied from 0° (at front side) to the wavelength selective reflection layer.
FIG. 5 is a graph showing reflection properties of a wavelength selective reflection layer of another holographic recording medium of the present invention to an incident light applied from an inclination angle of 20° to the wavelength selective reflection layer.
FIG. 6 is a schematic cross-sectional view exemplarily showing a holographic recording medium according to a first embodiment of the present invention.
FIG. 7 is a schematic cross-sectional view exemplarily showing a holographic recording medium according to a second embodiment of the present invention.
FIG. 8 is an illustration showing one example of the configuration of peripheral optical systems of a holographic recording medium of the present invention.
FIG. 9 is a block diagram showing one example of the total configuration of an optical recording and reproducing apparatus used in the present invention.

### DETAILED DESCRIPTION OF THE INVENTION

### (Composition for Holographic Recording Medium)

The composition for a holographic recording medium of the present invention contains a binder, a polymerizable monomer, and a photopolymerization initiator, and further contains additives and other components in accordance with the intended use.

### < Binder >

The binder is used for the purpose of enhancing effects of film performance, film strength and hologram recording properties.

For the binder, a polymer capable of forming a three-dimensional crosslinking structure by non-polymerization reaction is used. Here, "to form a three-dimensional crosslinking structure by non-polymerization reaction" means to form a three-dimensional crosslinking structure without covalent bonds but interaction between polymer chains, such as ionic bond, electrical interaction and microcrystallization.

When a polymer having a divalent or more ionic group is used, the above-noted three-dimensional crosslinking structure can be identified by the fact that when the polymer is added to an excess amount of solution, the polymer cannot be completely dissolved, although can be swelled therein. Further, in case of a polymer having crystal structure sites or ionic association sites, existence of the three-dimensional crosslinking structure can be identified by X-ray diffraction method based on the fact that for example, microscopic crystal sites or ionic association sites are formed into crosslinked points

As a polymer capable of forming a three-dimensional crosslinking structure by non-polymerization reaction, (A) a polymer which has an ionic group and formed a salt with constituted salt with the counterion of the ionic group and (B) a polymer having a crystal structure are exemplified.

### - (A) Polymer which has an ionic group and formed salt with the counterion of the ionic group -

The counterion in the polymer which has an ionic group and formed a salt with the counterion of the ionic group is not particularly limited and may be suitably selected in accordance with the intended use. Examples thereof include alkali metal ions, alkaline-earth metal ions, transition metal ions, organic ammonium ions, transition metal-organic amine complex ions, bonds between different types of polymer chains, and anions.

Examples of the alkali metal ions or alkaline-earth metal ions include Li⁺, Na⁺, Rb⁺, Cs⁺, Mg²⁺, Ca²⁺, Sr²⁺, Ba²⁺. In addition, Al³⁺ can also be used, though it is not categorized as the alkali metal ions and alkaline-earth metal ions.

Examples of the transition metal ions include Zn²⁺, Cu²⁺, Mn²⁺, Ni²⁺, and Co2⁺.

Examples of the organic ammonium ions include NH₄⁺, NHmRn⁺ (m + n =4) and ions represented by the following structural formula.

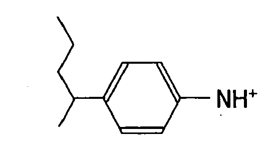

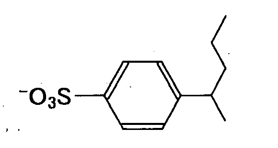

Examples of the transition metal-organic amine complex ions include [MRn]²⁺. Where "M" represents one selected from divalent Zn, divalent Cu, divalent Mn and pentavalent Co; and R represents an alkyl amine.

Examples of the anions include Cl⁻, Br-, and I⁻.

Of these counterions, Na⁺ and Zn²⁺ are typically used from the perspective of its stability.

Examples of the polymer which has an ionic group and formed a salt with the counterion of the ionic group include ionomer resins.

The ionomer resin means ionic resin having ion group in its polymer chain.

The ionomer resin means an ionic resin in which ionic groups are induced in its polymer chains.

It is assumed that hydrophilic groups coagulate in a hydrophobic matrix to cause microphase separation to form an ion aggregate like a multiplet or an ion associate, and the ion aggregate will be strongly crosslinked points, thereby a three-dimensional crosslinking structure is formed.

Examples of the ionomer resins include ethylene ionomer resins, styrene ionomer resins, perfluorocarbon ionomer resins, telechelic ionomer resins, and polyurethane ionomer resins. Of these ionomer resins, ethylene ionomer resins are preferable from the perspective that they are excellent in formability, heat adhesion, stability, and the like.

Examples of the ethylene ionomer resins include ethylene-methacrylate copolymer resins and ethylene-acrylate copolymer resins. In the present invention, a subject indicates both "methacryl" and "acryl" or any of them, it may be abbreviated as "(meth) acryl".

For commercially available products of the ethylene-methacrylate copolymer resin, ethylene-methacrylate copolymer zincate (426660, manufactured by Aldrich Co., methacrylic acid:15% by mass, melting point: 73°C, softening point: 61°C, melt viscosity: 14g/10 min), SURLYN (manufactured by DuPont Co.), HI-MILAN (manufactured by Mitsui DuPont Polychemical Co., Ltd), are preferably exemplified.

Examples of the styrene ionomer resin include styrene-methacrylate copolymer resins, styrene-sulfonate copolymer resins, and styrene-carboxylic acid copolymer resins.

Example of commercially available products of the perfluorocarbon ionomer resins include NAFION (manufactured by DuPont), ASIPLEX (manufactured by Asahi Kasei Corporation), FLEMION (manufactured by Asahi Glass Co.), and PFSI (manufactured by Dow Chemicals Co.).

Examples of the telechelic ionomer resin include α,ω-dicarboxylic acid telechelic polybutadienes.

Examples of commercially available products of the α,ω-dicarboxylic acid telechelic polybutadiene include HYCAR (manufactured by BFGoodrich Co.).

### - (B) Polymer having crystal structure -

The polymer having a crystal structure is assumed that structures constituting a crystal in a molecule make contact with each other to thereby form a three-dimensional crosslinking structure in a crystal form.

For the crystal structure in the polymer having a crystal structure, ethylene is preferably exemplified, from the perspective that ethylene has high crystallinity.

Thus, for the polymer having a crystal structure, ethylene copolymer resins are preferably exemplified.

For the ethylene copolymer resin, ethylene-carboxylic acid copolymer resins and ethylene-vinyl acetate copolymer resins are preferable from the perspective that the size of crystal thereof can be made small.

Examples of commercially available products of the ethylene-carboxylic acid copolymer resins include an ethylene-methacrylate copolymer resin (426628, manufactured by Aldrich Co.; methacrylic acid: 15% by mass, softening point: 62°C, melt viscosity: 60g/10 min), and an ethylene-acrylate copolymer resin (448672, manufactured by Aldrich Co.; acrylic acid: 15% by mass, melting point: 87 °C).

Example of commercially available products of the ethylene-vinyl acetate copolymer resins include an ethylene-vinyl acetate copolymer resin (340502, manufactured by Aldrich Co.; vinyl acetate: 40% by mass, melting point:110°C to 120°C); and EVERTATE and SUMITATE (both manufactured by Sumitomo Chemical Co., Ltd.).

The molecular mass of the polymer having a crystal structure is, for example, preferably 1,000 to 1,000,000, and more preferably 5,000 to 500,000 based on the mass average molecular mass.

The composition for a holographic recording medium of the present invention can be formed in a pellet, because a polymer capable of forming a three-dimensional crosslinking structure by non-polymerization reaction is used therein as the binder.

Specifically, the polymerizable monomer, and the photopolymerization initiator are mixed and dissolved in a solvent, then the binder is added thereto, and the solvent liquid is stirred at room temperature. The binder is dissolved or swelled in the solvent liquid, in which an undissolved binder is stirred in a swelled condition to impregnate the undissolved binder with the polymerizable monomer and the photopolymerization initiator until equilibrium. After the above-noted treatment, the solvent is removed from the binder pellet that reached equilibrium, and then the binder pellet is dried. The obtained composition is then pulverized, thereby a pellet composition for a holographic recording medium can be obtained.

In the present invention "pellet" means a conditoin that the viscosity at 32°C is 2,000 mPa·s or more, and it is in a state of glass at room temperature and does not adhere. The viscosity can be measured, for example, by a rheometer, DAR-50 (manufactured by Rheologica Instruments).

The content of the binder in the holographic recording layer is preferably 10% by mass to 98 % by mass, and more preferably 35 % by mass to 95% by mass to the total solid content of the holographic recording layer. When the content is less than 10% by mass, recorded holographic image may be significantly degraded with lapse of time, and when it is more than 98 % by mass, diffraction efficiency of the recorded holographic image is low, which may result in inefficient recording of holographic images.

### < Polymerizable monomer >

The polymerizable monomer is not particularly limited and may be suitably selected from among those known in the art. However, when considering adhesion properties to a base to be used for the holographic recording medium and the solubility in the binder, a compound having an acyloxy group or an acyamide group in a molecule thereof is preferable. Further, a compound having a (meth) acryloyl group is more preferable in view of steric hindrance at the time of radical polymerization. The (meth) acryloyl group mentioned in the present invention represents acryloyl group or methacryloyl group.

Examples of compounds having the (meth) acryloyl group, as compounds having one (meth) acryloyl group, include (meth) acrylates and (meth)acrylamides of phenol, nonylphenol and 2-ethylhexanol; (meth) acrylates and (meth)acrylamides of alkylene oxide adducts of the alcohols thereof.

Examples of compounds having two (meth)acryloyl groups include di(meth) acrylates of bisphenol-A, isocyanurate, and fluorene, and di(meth) acrylates and (meth) acrylamides of polyalkylene glycol such as ethylene glycol and propylene glycol.

Examples of compounds having three (meth) acryloyl groups include poly(meth) acrylates and poly(meth) acrylamides of pentaerythritol and dipentaerythritol.

In addition, conventionally known acrylates or acrylamide monomers and acrylamide oligomers such as urethane acrylates each having a urethane bond in its main chain, polyester acrylates each having an ester bond in its main chain, and epoxy (meth) acrylates of which an acrylic acid added to an epoxy compound, can be suitably selected for use in the present invention.

The compound having a plurality of (meth) acryloyl groups may have (meth) acrylate singularly or (meth) acrylamide singularly, or may be a compound having both (meth) acrylate and (meth) acrylamide.

To make the composition for a holographic recording medium have a conspicuous difference in refractive index between a three-dimensional crosslinking structure formed by the binder (hereafter may be called "binder matrix" or "three-dimensional polymer matrix") and a polymerizable monomer having an ethylene double bond that can be obtained by diffusion/polymerization reaction, as a refractive index of the polymerizable monomer, it is preferable to use a compound having a higher refractive index than that of the binder and/or the crosslinking agent or a polymerizable monomer having a lower refractive index than that of the same. Particularly when a compound having a refractive index of around 1.47 is used for the binder compound and/ or the crosslinking agent, it is preferable to use a compound having a refractive index of 1.52 or more for the polymerizable monomer in terms that a polymer of a polymerizable monomer having high refractive index can be obtained.

Specific examples of the polymerizable monomer include acryloyl morpholine, phenoxyethyl acrylate, isobornyl acrylate, 2-hydroxypropyl acrylate, 2- ethylhexyl acrylate, 1,6- hexanediol diacrylate, tripropylene glycol diacrylate, neopentyl glycol propylene oxide (PO)-modified diacrylate, 1.9- nonanediol diacrylate, hydroxyl pivalic acid neopentyl glycol diacrylate, ethylene oxide (EO)-modified bisphenol A diacrylate, polyethylene glycol diacrylate, pentaerythritol triacrylate, pentaerythritol tetraacrylate, pentaerythritol hexaacrylate, EO-modified glycerol triacrylate, trimethylol propane triacrylate, EO-modified trimethylol propane triacrylate, 2-napht-1-oxyethyl acrylate, 2-carbazoyl -9-yl-ethyl acrylate, (tri-methyl silyloxy) dimethylsilyl propyl acrylate, vinyl-1-naphthoate, N-vinyl carbazole, 2.4.6-tribromophenyl acrylate, EO-modified tribromophenyl acrylate, pentabromophenyl acrylate, phenylthioethyl acrylate, tetrahydrofurfuryl acrylate, and styrene.

Each of these polymerizable monomers may be used alone or in combination with two or more.

The content of the polymerizable monomer in the holographic recording layer is preferably 2% by mass to 80% by mass, more preferably 2% by mass to 70% by mass, and particularly preferably 3% by mass to 20% by mass to the total solid content of the holographic recording layer. When the content is less than 2% by mass, sufficient diffraction efficiency may not be obtained, and when the content is more than 80% by mass, the resolution of holographic recording may degrade, and the recording density may not be improved.

### < Photo Polymerization initiator >

The photopolymerization initiator is not particularly limited as long as it can be an initiator to initiate a chemical reaction by light, and may be suitably selected in accordance with the intended use.

Examples thereof include 2.2'-bis (o-chlorophenyl) -4.4'.5.5'- tetraphenyl-1, 1'-biimidazol, 2.4.6-tris (trichloromethyl)-1.3.5-triazine, 2.4-bis (trichloromethyl) -6- (p-methoxyphenyl)-1.3.5- triazine, benzoin, 2-hydroxy-2-methyl-1-phenylpropan-2-one, benzophenone, thioxanthene, 2.4.6-trimethyl benzoyl diphenyl acylphosphine oxide, triphenylbutyl borate tetraethyl ammonium, bis (η-5-2,4-cyclopentadiene-1-yl) bis [2,6-difluoro-3-(1H-pyrrole-1-yl)] phenyl titanium, and compounds in their molecules, having light absorbing sites and active sites which generate free radicals described in Japanese Patent Application Laid-Open (JP-A) No. 2005-49608. Each of these photopolymerization initiators may be used alone or in combination with two or more.

Further, a sensitizing dye may be used in combination in accordance with the wavelength of light used for irradiation.

Examples of the sensitizing dye include merocyanine dyes, cyanine dyes, squarium dyes, dibenzyl acetone dyes, xanthene dyes, triphenylmethane dyes, acridinium dyes, or derivatives of thioxanthone, anthracene, phenanthrene, pyrene, acridine, carbazole, and phenothiazine.

The content of the photopolymerization initiator in the holographic recording layer is preferably 0.01 % by mass to 20% by mass, and more preferably 0.1% by mass to 5% by mass to the total solid content of the holographic recording layer. When the content is less than 0.01 % by mass, the photosensitivity may be low at the time of recording and reproducing, and the multiple recording property may be degraded. When the content is more than 20% by mass, it may induce crystal deposition at storage of holographic image to cause light scattering, resulting in degradation of reading recorded information.

### < Additives >

Polymerization inhibitors and antioxidants for photopolymers may be added as additives for the purpose of improving storage stability of the recording layer. Examples of the polymerization inhibitors and antioxidants include hydroquinone, p-benzoquinone, hydroquinone monomethyl ether, 2.6-di-tertiary-butyl-p-cresol, 2.2'-methylene bis (4-methyl-6-tertiary-butyl phenol), triphel phosphite, tris-nonylphenyl phosphate, phenothiazine, and N-isopropyl-N'-phenyl-p- phenylenediamine.

The content of the additives is preferably 3% by weight or less to the total content of the polymerizable monomer to be used for the composition for a holographic recording medium. When the content is more than 3% by weight, polymerization reaction may delay or when it is conspicuous, the photopolymer may not be polymerized.

Besides the above-noted additives, thermal expansion agents to prevent thermal shrinkage after recorded, plasticizer to adjust viscosity at preparation of a composition for holographic recording medium, and thermofusible compounds may be suitably selected for use.

### (Holographic Recording Medium)

The holographic recording medium of the present invention has at least a substrate, a holographic recording layer containing the composition for a holographic recording medium, and a wavelength selective reflection layer formed between the substrate and the holographic recording layer and further has a first gap layer, a second gap layer and other layers in accordance with necessity.

### [Holographic Recording Layer]

The holographic recording layer can be formed by depositing the composition for a holographic recording medium in between two substrates composed of the first substrate and the second substrate. On the holographic recording layer, information can be recorded by utilizing holography. By using the composition for a holographic recording medium as a material of the holographic recording layer, a material which can change optical properties such as absorption coefficient and refractive index in accordance with the irradiation intensity when the holographic recording medium is irradiated with electromagnetic wave having a predetermined wavelength, high density recording and accurate reproducing of the recorded information are enabled.

For example, a gasket to hold the composition for a holographic recording medium of the present invention is attached to the substrate, and the composition for a holographic recording medium is deposited in between the two substrates, thereby the deposition is enabled.

For material of the substrate, glass is typically used as described hereinafter. Besides glass, other materials which are transparent to irradiation light used in data recording, for example, plastics such as polycarbonate, poly(methyl) methacrylate, cyclic olefin ring-opening polymer can also be used. The composition for a holographic recording medium can also be deposited by placing a spacer to form a holographic recording layer with a desired thickness in between the two substrates.

To deposit the composition for a holographic recording medium in between the two substrates, the composition for a holographic recording medium may be heaped in deposite spaces formed with a gasket by using a dispenser, or by forming the composition in a film, punching out the film-like composition in a discotic shape, and bonding it to the substrates by vacuum lamination, however, it is preferable to heap the composition for a holographic recording medium on one of the substrates because the composition can be formed in pellets as described above.

A three-dimensional polymer matrix can be formed by depositing the composition for a holographic recording medium in between the two substrates in this way, heating it, and leaving it as it is for a specific length of time, i.e., by hot press method.

In other words, it is possible to prevent a transfer of a polymer formed of the diffused and polymerized polymerizable compound from migrating inside the holographic recording layer.

After information is recorded on the holographic recording medium, it is preferable to polymerize a remaining binder and polymerizable compound by light, and heat to be applied in accordance with necessity for the purpose of fixing the recorded holographic information. In this instance, light used for exposure is preferably applied to the entire of the holographic recording medium at a time.

The thickness of the holographic recording layer is preferably 1 µm to 5,000 µm, and more preferably 100 µm to 1,000 µm. When the thickness is less than 1 µm, it may be difficult to obtain a high recording capacity by multiple recording. When the thickness is more than 5,000 µm, S/N ratio may be degraded by light scattering in the holographic recording medium. When the thickness is within the preferable range, a sufficient S/N ratio can be obtained even when 10-fold to hundreds-fold of multiple recording is performed. When the thickness within the more preferable range, it is advantageous because the above-noted effect is remarkably exhibited.

### [Substrate]

The substrate is not particularly limited as to its shape, structure, size and the like, and may be suitably selected in accordance with the intended use. Examples of the shape include discs and cards. There is a need to select a material that can ensure mechanical strength of the holographic recording medium. When a light beam used for recording and reproducing is incident through a substrate, it is necessary that the material be sufficiently transparent in the wavelength range of the light beam to be used.

For the substrate, a substrate having a servo pit pattern is preferable, and a substrate further having a reflection surface on the servo pit pattern is more preferable.

For material of the substrate, typically, glass, ceramics, resins and the like are used, however, resins are particularly preferable in terms of its formability and cost.

Examples of the resin include polycarbonate resins, acryl resins, epoxy resins, polystyrene resins, acrylonitrile-styrene copolymer resins, polyethylene resins, polypropylene resins, silicon resins, fluorine resins, ABS resins, and urethane resins. Of these, polycarbonate resins and acryl resins such as polymethyl methacrylate are particularly preferable in terms of its formability and optical properties and cost.

For the substrate, a suitably synthesized one or a commercially available one may be used.

On the substrate, address servo areas are formed at regular intervals and at a specific angle as a plurality of positioning areas extending in a linear form in the radius direction, and fan-shaped intervals between adjacent address servo areas are data areas. In the address servo areas, information to perform control focus servo control and tracking servo control by a sampled servo method and address information is preliminarily recorded or pre-formatted by embossed pits (servo pits). The focus servo can be controlled using the reflection surface. For the information to perform tracking servo control, for example, a wobble pits can be used. When the holographic recording medium is a card shaped, a servo pit pattern may be omitted.

The thickness of the substrate is not particularly limited and may be suitably selected in accordance with the intended use. It is preferably 0.1 mm to 5 mm, and more preferably 0.3 mm to 2 mm. When the thickness of the substrate is less than 0.1 mm, it may be difficult to prevent distortion of the disc shape at the storage, and when the thickness is more than 5 mm, the total weight of the disc is heavy, and an excessive load may be applied on the drive motor.

### < Reflection Surface >

The reflection surface is formed on the surface of the servo pit pattern of the substrate.

For a material of the reflection surface, a material which has a high reflectance to recording beam and reference beam is preferably used. When the wavelength of the light to be used is 400 nm to 780 nm, for example, it is preferable to use Al, Al alloy, Ag, Ag alloy and the like for the material of the reflection surface. When the wavelength of the light to be used is 650 nm or more, Al, Al alloy, Ag, Ag alloy, Au, Cu alloy, TiN and the like are preferably used.

The reflection surface serves to reflect light as well as enables recording and rewriting directory information etc., in which information on up to which area a hologram is recorded, when holographic images are rewritten, where an error resides, how a replacement processing is performed and the like, using a holographic recording medium that enables any one of recording information and erasing information, for example, a DVD (digital video disc) without affecting holographic images.

The forming method of the reflection surface is not particularly limited and may be suitably selected in accordance with the intended use. For example, various vapor deposition methods can be employed, such as vacuum deposition method, spattering method, plasma CVD method, photo CVD method, ion plating method, electron beam deposition method. Of these methods, spattering method is preferable in terms of mass-productivity and film quality and the like.

The thickness of the reflection surface is preferably 50 nm or more, and more preferably 100 nm or more such that a sufficient reflectance can be achieved.

### [Wavelength Selective Reflection Layer]

The wavelength selective reflection layer has a function to prevent diffused reflection of information beams and reference beams from the reflection surface of the holographic recording medium and prevent occurrence of noise without causing misalignment of selective reflection wavelength even when the incident angle is changed. By laminating the wavelength selective reflection layer on the optical recording medium, optical recording with high resolution and high diffraction efficiency can be obtained.

For a filter function for optical recording medium, it is preferable that a light beam having a first wavelength is transmitted, and a light having a second wavelength that differs from the light having the first wavelength is reflected. The light having the first wavelength preferably has a wavelength of 350 nm to 600 nm, and the light having the second wavelength preferably has a wavelength of 600 nm to 900 nm. For this end, an optical recording medium having a structure in which an optical recording layer, a wavelength selective reflection layer, and a servo pit pattern are formed in this order in a laminate structure as viewed from the used optical system is preferable.

The light transmittance of the wavelength selective reflection layer at a wavelength of 655 nm, at an incident angle of ±40°C, is typically 50% or more, preferably 80% or more, and the light transmittance at wavelength of 532 nm is typically 30% or more and preferably 40% or more.

The wavelength selective reflection layer is not particularly limited and may be suitably selected in accordance with the intended use. For example, the wavelength selected reflection layer is formed with a laminate composed of a dielectric deposition layer, a single layer or two or more layers of cholesteric layer(s), and further, other layers in accordance with necessity. The wavelength selective reflection layer may also have a colorant-containing layer. Details of the colorant-containing layer can be referred to Japanese patent Application Laid-Open (JP-A) No. 2004-352084.

For the wavelength selective reflection layer, a wavelength selective reflection layer may be directly laminated together with an optical recording layer on the substrate by a coating method, or a wavelength selective reflection layer may be laminated on a base such as film to prepare a filter for optical recording medium and the filter for optical recording medium may be laminate on a substrate.

### < Dielectric Deposition Layer (Dichroic Mirror Layer) >

The dielectric deposition layer is composed of a plurality of dielectric thin films having a different refractive index each other. To make a wavelength selective reflection layer with the dielectric deposition layer, it is preferable that a plurality of dielectric thin films having a high refractive index and a plurality of dielectric thin films having a low refractive index are alternately deposited, however, the number of types of the dielectric thin film is not limited to two, and may be two or more. When a colorant-containing layer is formed, it is formed under the dielectric deposition layer.

The number of deposited layers of the dielectric thin films is preferably 2 to 50 to 50, more preferably 4 to 20, and particularly preferably 6 to 15. When the number of deposited layers is more than 50, the production efficiency is reduced by deposition of multiple layers, the objects and effects of the present invention may not be achieved.

The order of lamination of the dielectric thin films is not particularly limited and may be suitable selected in accordance with the intended use. For example, when the refractive index of an adjacent film is high, a film having a lower refractive index than that of the adjacent film is first deposited. In contrast, when the refractive index of an adjacent film is low, a film having a higher refractive index than that of the adjacent film is first deposited. The threshold to determine if the refractive index is high or low is preferably 1.8. However, if the refractive index is high or low is not absolute, and among materials having a high refractive index, a material having a relatively high refractive index and a material having a relatively low refractive index may be present, and they may be alternatively deposited.

Material of the dielectric thin film having a high refractive index is not particularly limited and may be suitably selected in accordance with the intended use. Examples thereof include Sb₂O₃, Sb₂S₃, Bi₂O₃, CeO₂, CeF₃, HfO₂, La₂O₃, Nd₂O₃, Pr₆O₁₁, Sc₂O₃, SiO, Ta₂O₅, TiO₂, TlCl, Y₂O₃, ZnSe, ZnS, and ZrO₂. Of these, Bi₂O₃, CeO₂, CeF₃, HfO₂, SiO, Ta₂O₅, TiO₂, Y₂O₃, ZnSe, ZnS, and ZrO₂ are preferable, and of these, SiO, Ta₂O₅, TiO₂, Y₂O₃, ZnSe, ZnS, and ZrO₂ are more preferable.

Material of the dielectric thin film having a low refractive index is not particularly limited and may be suitably selected in accordance with the intended use. Examples thereof include Al₂O₃, BiF₃, CaF₂, LaF₃, PbCl₂, PbF₂, LiF, MgF₂, MgO, NdF₃, SiO₂ Si₂O₃, NaF, ThO₂ and ThF₄. Of these, Al₂O₃, BiF₃, CaF₂, MgF₂, MgO, SiO₂, and Si₂O₃ are preferable, and of these, Al₂O₃, CaF₂, MgF₂, MgO, SiO₂, and Si₂O₃ are more preferable.

The atomic ratio of the dielectric thin film is not particularly limited and may be suitably adjusted in accordance with the intended use. The atomic ratio can be adjusted by changing atmospheric gas concentration when forming thereof.

The method of forming the dielectric thin film is not particularly limited and may be suitably selected in accordance with the intended use. Examples thereof include vacuum deposition method (PVD method) such as ion plating and ion beam, physical vapor deposition method (PVD method) such as spattering and chemical vapor deposition method (CVD method). Of these, vacuum deposition method and spattering are preferable, and spattering is more preferable.

For the sputtering method, for example, DC sputtering method is preferable because high layer-forming rate can be obtained. In DC sputtering method, it is preferable to use a material having high conductivity. For methods of forming the dielectric thin film in multiple layers by sputtering, there are methods, for example, (1) a single chamber process in which a plurality of targets are used by using one chamber to form layers alternately or in a specific order, and (2) a multi-chamber process in which a plurality of targets are used by using a plurality of chambers to form layers in succession. Of these, the multi-chamber process is preferable from the perspective of its productivity, and that material contamination can be prevented.

The thickness of the dielectric thin film is preferably λ/16 to λ, more preferably λ/8 to 3λ/4, and still more preferably λ/6 to 3λ/8 as expressed in optical wavelength order.

### < Cholesteric Liquid Crystal Layer >

The cholesteric liquid crystal layer contains at least a nematic liquid crystal compound and a photoreactive chiral compound, and also contains a polymerizable monomer and other components in accordance with necessity.

For material of the cholesteric liquid crystal layer in the wavelength selective reflection layer, a photoreactive chiral compound is used, and the spiral pitch of the liquid crystal is continuously changed in the thickness direction of the liquid crystal layer. The light reflectance in the rage of wavelength of λ₀ to λ₀ /cos20° (λ₀ is a wavelength of light used for irradiation) when the vertical incident angle is determined as 0° and the incident light angle is set within 0°±20° is preferably 40% or more. The light reflectance in the rage of wavelength of λ₀ to λ₀/cos40° (λ₀ is a wavelength of light used for irradiation) when the vertical incident angle is determined as 0° and the incident light angle is set within 0°±20° is preferably 40% or more.

When the light reflectance in the range of wavelength of λ₀ to λ₀/cos20°, particularly in the range of λ₀ to λ₀/cos40° is 40 % or more, problems with angle dependency of irradiation light can be resolved, and optical lens systems, which are usually used in holographic recording medium, can be used.

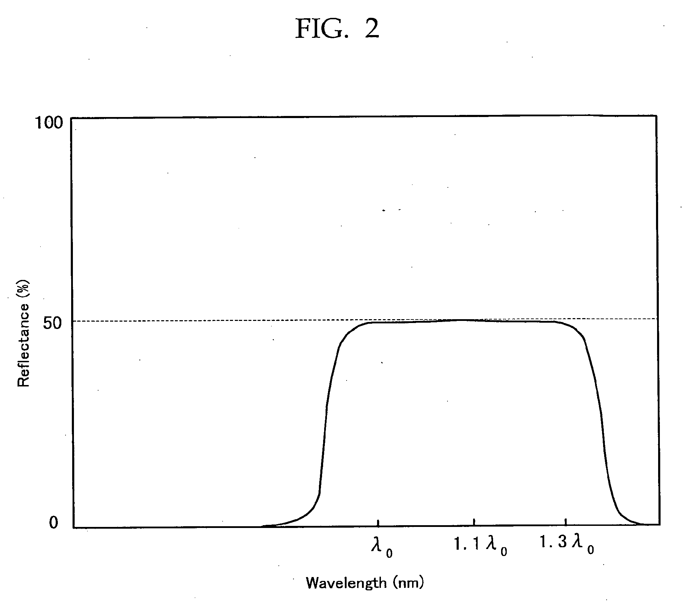

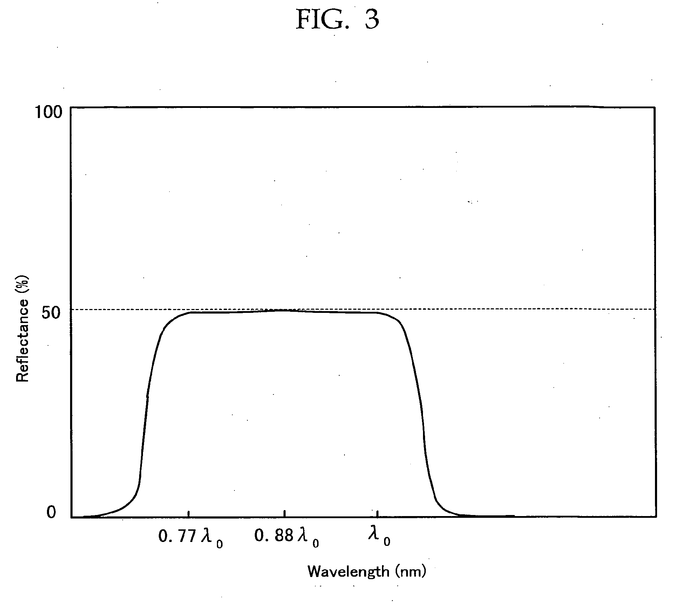

More specifically, for the chiral compound, a photoreactive chiral compound that has photo-reactivity and is capable of largely changing the spiral pitch of liquid crystal by light is used, and the content of the photoreactive chiral compound and UV irradiation time are adjusted, thereby a wavelength selective reflection layer for holographic recording media in which the spiral pitch is continuously changed in the thickness direction of the liquid crystal layer can be obtained. FIG. 2 shows that the reflectance to a vertical incident light applied from the front direction (0°) to the wavelength selective reflection layer is 40% or more. In the meanwhile, the reflection properties gradually shift toward shorter wavelength side when the incident light is applied at an inclination angle to the wavelength selective reflection layer, and then the reflection properties shown in FIG. 3 are exhibited when the incident angle is inclined at 40° in the liquid crystal layer.

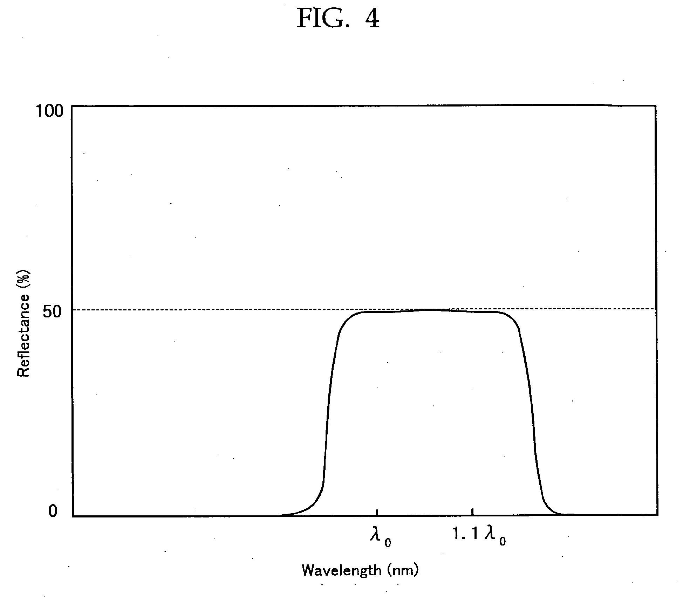

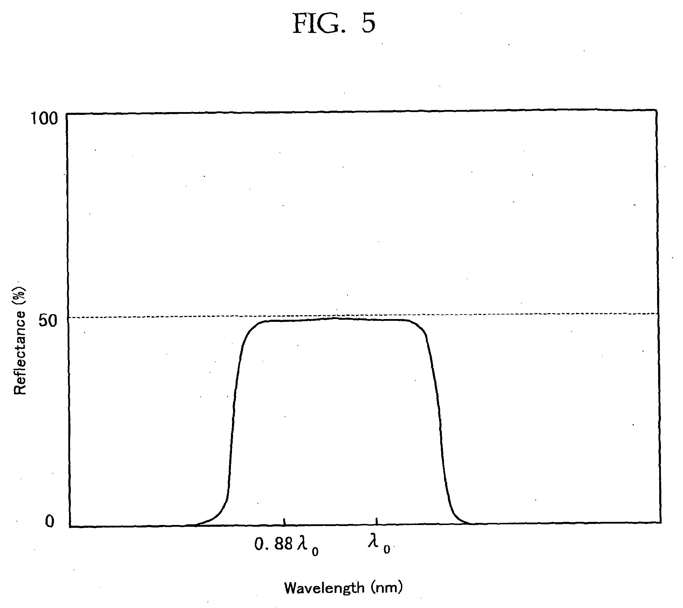

Similarly, when the spiral pitch is continuously changed in the thickness direction of the liquid crystal layer by adjusting the content of the photoreactive chiral compound and UV irradiation time, a wavelength selective reflection layer for holographic recording media having reflection properties as shown in FIG. 4 can be obtained. FIG. 4 shows that the reflectance to a vertical incident light applied from the front direction (0°) to the wavelength selective reflection layer is 40% or more. In the meanwhile, the reflection properties gradually shift toward shorter wavelength side when the incident light is applied at an inclination angle to the wavelength selective reflection layer, and then the reflection properties shown in FIG. 5 are exhibited when the incident angle is inclined at 20° in the liquid crystal layer.

In case of the reflection region shown in FIG. 2, when λ₀ is 532 nm, 1.3λ₀ is equal to 692 nm, and when the wavelength of the servo light is 655 nm, the servo light is reflected. The reflection region of λ₀ to 1.3λ₀ herein is suitable for an incident light applied at an angle of ±40° to the wavelength selective reflection layer, and when such a substantially inclined incident light is actually employed, a servo light can be controlled without any troubles by masking the servo light within the incident light angle of ± 20°. Further, it is easy to design all the incident light angles within the incident light angle of ±20° in a wavelength selective reflection layer to be used by sufficiently widening the spiral pitch of the cholesteric liquid crystal layer in the wavelength selective reflection layer. In this case, the cholesteric liquid crystal layer for wavelength of λ₀ to 1.1λ₀ as shown in FIG. 4 can be used, causing no problem with servo light transmission.

Accordingly, from the results as shown in FIGS. 2 to 5, a reflectance of 40% or more can be ensured, even when the incident light angle is inclined from 0° to 20° (preferably 0° to 40°) to the wavelength selective reflection layer of the holographic recording medium of the present invention, and thus a wavelength selective reflection layer for holographic recording medium that has no problem with reading of signals can be prepared.

As for the cholesteric liquid crystal layer, a cholesteric liquid crystal layer having a circularly polarized light separating function is preferable. In the cholesteric liquid crystal layer having a circularly polarized light separating function, the rotational direction of the spiral of liquid crystal (clockwise direction or counterclockwise direction) agrees with the circularly polarized light direction, and selective reflection property is held to reflect only circularly polarized light components whose wavelengths agree with the spiral pitch of the liquid crystal. By utilizing the selective reflection properties of the cholesteric liquid crystal layer, the cholesteric liquid crystal layer transmits and separates only circularly polarized lights having a specific wavelength from natural lights having a constant wavelength band, and reflects only the remaining lights.

Thus, the cholesteric liquid crystal layer preferably transmits a light having a first wavelength and reflects a circularly polarized light having a second wavelength having a different wavelength from the light having the first wavelength. It is preferable that the wavelength of the light having a first wavelength is 350 nm to 600 nm and the wavelength of the light having a second wavelength is 600 nm to 900 nm.

The width of wavelength range of the wavelength selective reflection layer of the cholesteric liquid crystal layer is preferably 100 nm or more, and more preferably 150 nm to 300 nm. When the wavelength band width is less than 100 nm, the reflection applicability to an incident light within an incident angle of ±20° may be insufficient.

The wavelength range of the cholesteric liquid crystal layer is preferably continuous. The term "be continuous" means that there is no gap in the wavelength range of λ₀ to λ₀/cos20° (preferably, range of λ₀ to λ₀/cos40°) and the reflectance at a wavelength within the range is substantively 40% or more.

### - Nematic Liquid Crystal Compound -

The nematic liquid crystal compound is characterized in that the liquid crystal phase is solidified under the liquid crystal transition temperature. The nematic liquid crystal compound can be suitably selected from polymer liquid crystal compounds and polymerizable liquid crystal compounds each having a refractive index anisotropy Δn of 0.10 to 0.40. A liquid crystal of such a crystal compound in a state of fused liquid crystal is oriented by using an orientation substrate that has been subjected to an orientation treatment such as rubbing treatment, or the like, and the nematic liquid crystal compound is cooled as it is and solidified to thereby use it as a solid phase.

The nematic liquid crystal compound is not particularly limited and may be suitably selected in accordance with the intended use. Examples thereof include the following compounds.

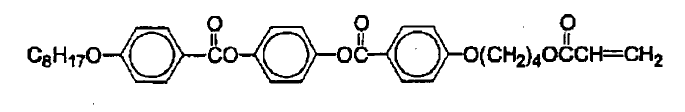

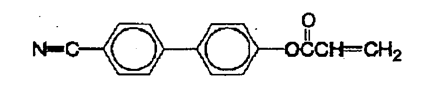

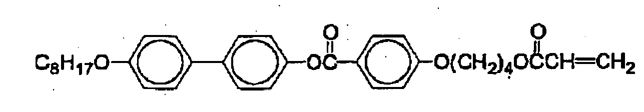

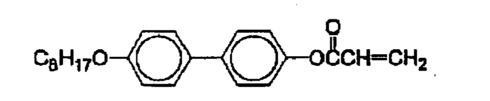

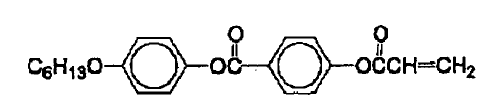

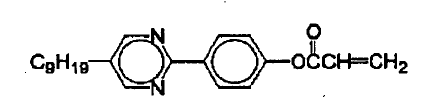

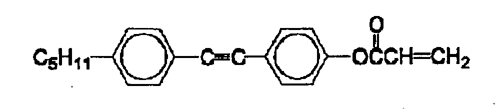

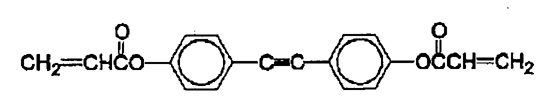

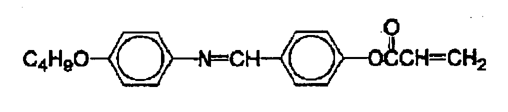

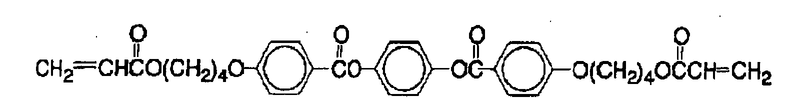

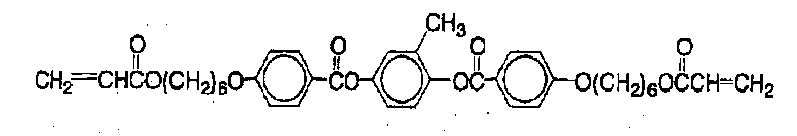

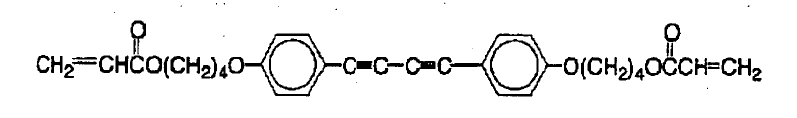

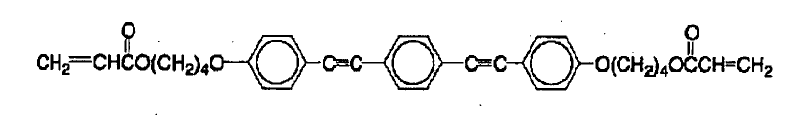

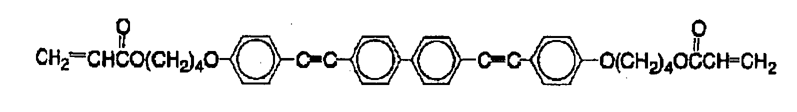

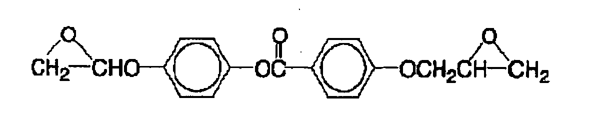

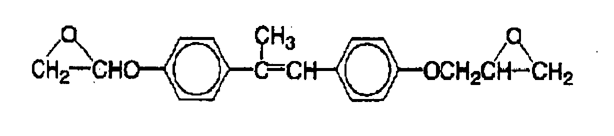

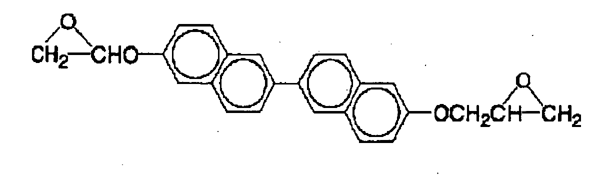

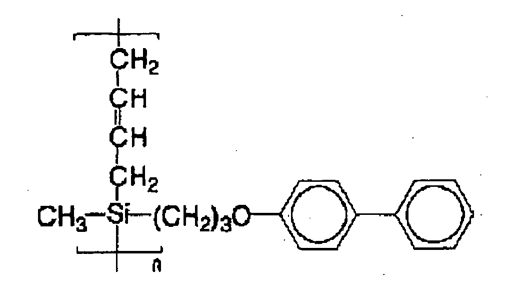

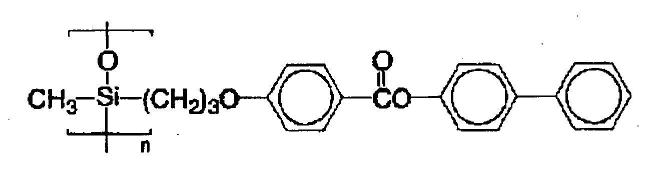

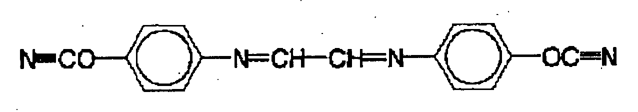

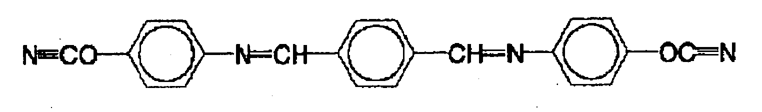

In the above structural formulas, "n" means an integer of 1 to 1,000. In each of the examples of compounds, compounds that the side chain linking groups of the each of the example of compounds are changed to any of the following structures are also preferably exemplified for the nematic liquid crystal compound.

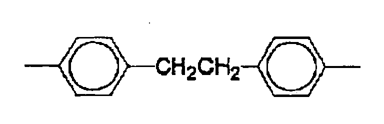

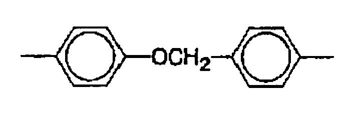

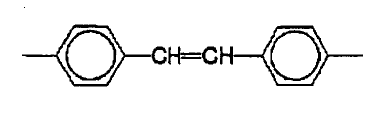

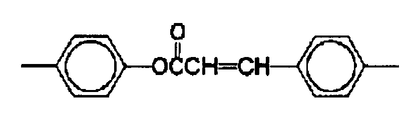

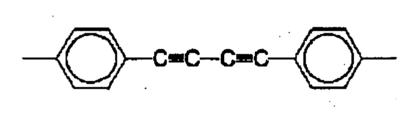

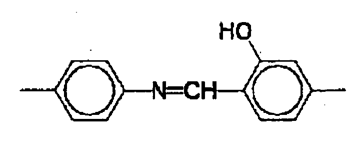

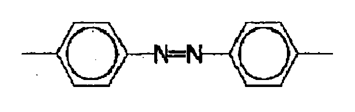

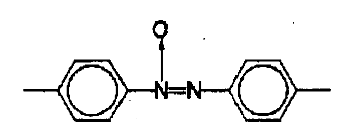

Of the above mentioned examples of compounds, for nematic liquid crystal compounds, nematic liquid crystal compounds having polymerizable groups in its molecule is preferable from the perspective of ensuring sufficient hardness thereof, and of these, UV polymerizable liquid crystal is particularly preferable. For the UV polymerizable liquid crystal, commercially available products can be used. Examples of the commercially available products thereof include product name: PALIOCOLOR LC242 manufactured by BASF Corporation; product name: E7 manufactured by Merck; LC-Silicon-CC3767, manufactured by Wacker-Chem; and product name: L35, L42, L55, L59, L63, L79, and L83, manufactured by Takasago International Corporation.

The content of the nematic liquid crystal compound is preferably 30% by mass to 99% by mass, and more preferably 50% by mass to 99% by mass to the total solid content of the cholesteric liquid crystal layer. When the content is less than 30% by mass, the orientation degee of the nematic liquid crystal compound may be insufficient.

### - Photoreactive Chiral Compound -

The photoreactive chiral compound means a chiral compound having photo-reactivity and is capable of greatly changing the spiral pitch by exposure of light.

The chiral compound has chiral sites and a photoreactive group. The chiral sites are preferably at least one selected from isosorbide compounds, isomannide compounds, and binaphthol compounds.

For the photoreactive group, a group that induces an anisotropy from trans to cis of carbon-carbon double bond is preferable.

The isosorbide compound is not particularly limited and may be suitably selected in accordance with the intended use. Examples thereof are those described in Japanese Patent Application Laid-Open (JP-A) No. 2002-80851, JP-A No. 2002-179681, JP-A No. 2002-179682, JP-A No. 2002-338575, JP-A No. 2002-338668, JP-A No. 2003-306490, JP-A No. 2003-306491, JP-A No. 2003-313187, JP-A No. 2003-313292, JP-A No. 2003-313189.

The isomannide compound is not particularly limited and may be suitably selected in accordance with the intended use, and examples thereof include those described in Japanese Patent Application Laid-Open (JP-A) No. 2002-80478, and JP-A No. 2003-313188.

The binaphthol compound is not particularly limited and may be suitably selected in accordance with the intended use, and examples thereof include those described in Japanese Patent Application Laid-Open (JP-A) No. 2002-302487, JP-A No. 2002-179670, and JP-A No. 2002-179669.

As specific example of the photoreactive chiral compound, the followings are exemplified. 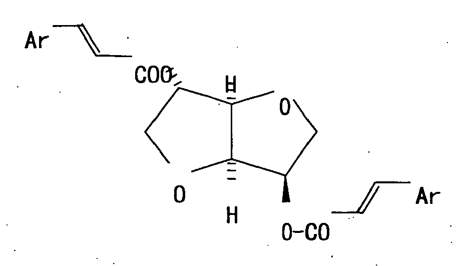 Where "Ar" represents one of the following formulas (1) to (6). 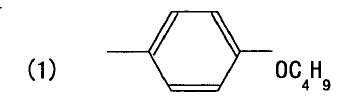 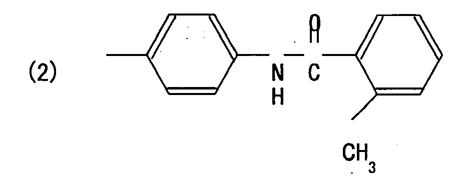 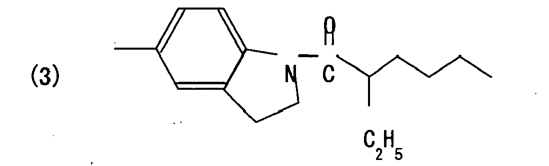 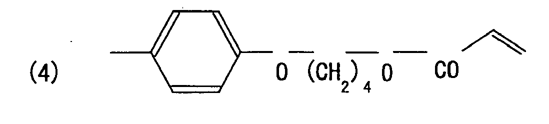 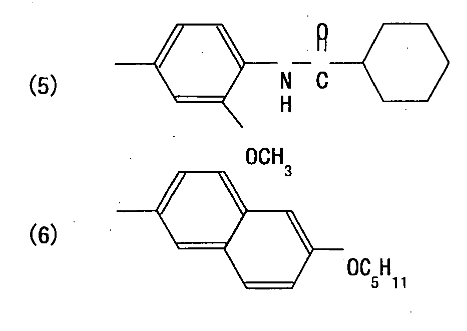 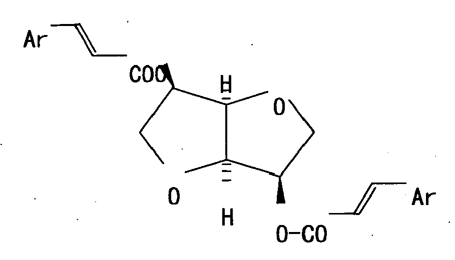 Where "Ar" represents one of the following Formulas (7) to (12).

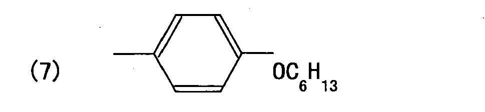

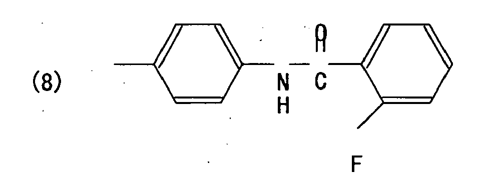

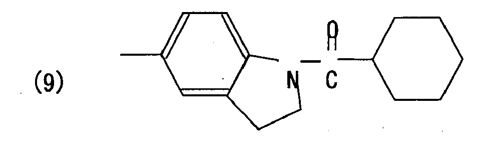

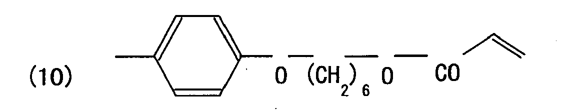

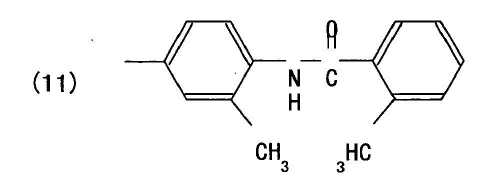

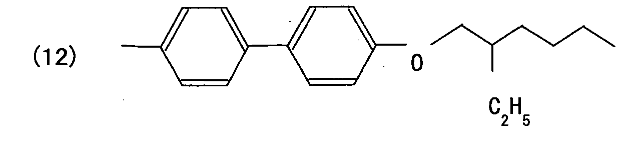

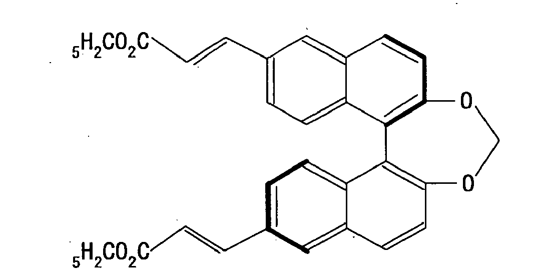

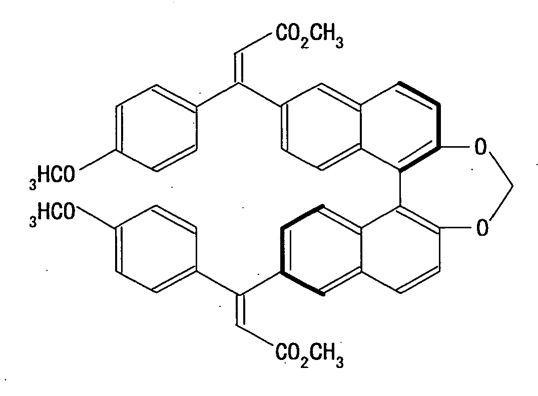

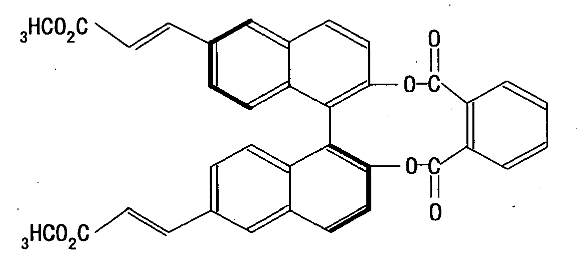

The content of the chiral compound is preferably 1% by mass to 30% by mass, and more preferably 1% by mass to 20% by mass to the total solid content of the cholesteric liquid crystal layer. When the content is less than 1 % by mass, the spiral pitch is excessively long, and it may deviate from a selectable wavelength that can be employed for optical systems. When the content is more than 30% by mass, the orientation degree of the cholesteric liquid crystal layer may be insufficient.

### - Polymerizable Monomer -

For the cholesteric liquid crystal layer, a polymerizable monomer can be used in combination for enhancing hardness degree such as film strength. With the use of a polymerizable monomer, after changing distortion force of a liquid crystal by exposure of light (patterning), (for example, after forming a distribution of selective reflection wavelengths), the spiral structure of the liquid crystal (selective reflectivity) can be fixed, and the strength of the fixed cholesteric liquid crystal layer can be enhanced. However, when the liquid crystal compound has also a polymerizable group in its same molecule, a polymerizable monomer is not necessarily added.

The polymerizable monomer is not particularly limited and may be suitably selected from among those known in the art in accordance with the intended use. Examples thereof include monomers having an ethylene unsaturated bond. Specifically, polyfunctional monomers such as pentaerythritol tetraacrylate, dipentaerythritol hexaacrylate are exemplified.

Specific examples of the monomer having an ethylene unsaturated bond include compounds represented by the following structural formulas. Each of these compounds may be used alone or in combination with two or more.

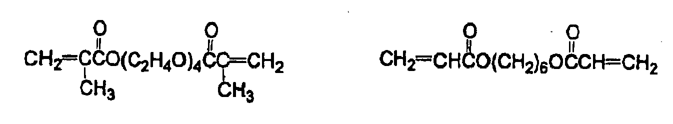

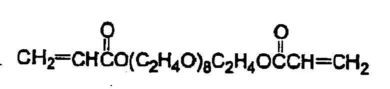

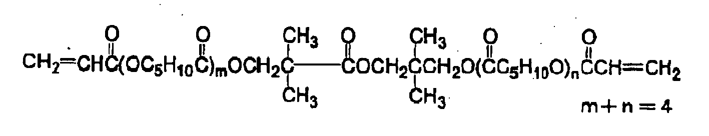

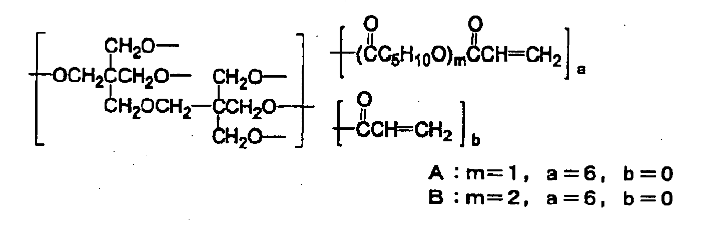

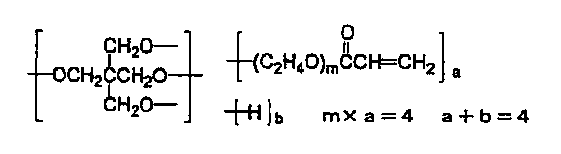

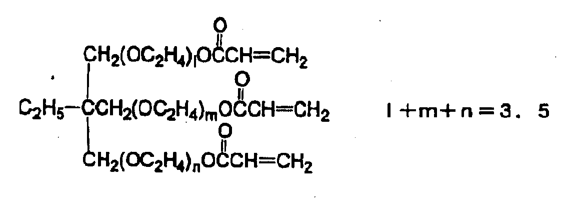

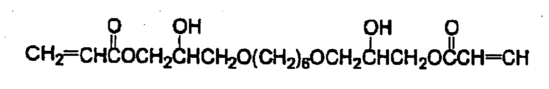

The added amount of the polymerizable monomer is preferably 0% by mass to 50% by mass, and more preferably 1% by mass to 20% by mass to the total solid content of the cholesteric liquid crystal layer. When the added amount is more than 50% by mass, it may inhibit orientation of the cholesteric liquid crystal layer.

### - Other Components -

The other components are not particularly limited and may be suitably selected in accordance with the intended use. Examples thereof include photopolymerization initiators, sensitizers, binder resins, polymerization inhibitors, solvents, surfactants, thickening agents, coloring materials, pigments, UV absorbers, and gelatinizing agent.

The photopolymerization initiator is not particularly limited and may be suitably selected from among those known in the art. Examples thereof include p-methoxy phenyl-2,4-bis(trichloromethyl)-s-triazine, 2-(p-butoxystyryl)-5-trichloromethyl 1,3,4-oxadiazole, 9-phenyl acridine, 9,10-dimethyl benzphenazine, benzophenone/Michler's ketone, hexaaryl biimidazole/mercapto benzimidazole, benzyl dimethyl ketal, and thioxanthone/amine. Each of these photopolymerization initiators may be used alone or in combination with two or more.

For the photopolymerization initiator, commercially available products can be used. Examples of the commercially available products include IRGACURE 907, IRGACURE 369, IRGACURE 784, IRGACURE 814 manufactured by Chiba Specialty Chemicals K.K.; and LUCIRIN TPO manufactured by BASF Corporation.

The added amount of the photopolymerization initiator is preferably 0.1% by mass to 20% by mass, and more preferably 0.5% by mass to 5% by mass to the total solid content of the cholesteric liquid crystal layer. When the added amount is less than 0.1% by mass, it may take a long time for irradiation of light because of its low hardening efficiency. When the added amount is more than 20% by mass, the light transmittance from UV-visible resin to visible light region may be lowered.

The binder resin is not particularly limited and may be suitably selected from among those known in the art. Examples thereof include polyvinyl alcohols; polystyrene compounds such as polystyrene and poly-α-methylstyrene; cellulose resins such as methylcellulose, ethylcellulose and acetylcellulose; acidic cellulose derivatives having a carboxyl group on its side chain; acetal resins such as polyvinyl formal and polyvinyl butyral; methacrylic acid copolymers, acrylic acid copolymers, itaconic acid copolymers, croton acid copolymers, maleic acid copolymers, partially esterified maleic acid copolymers; acrylic acid alkyl esters homopolymer, meta acrylic acid alkyl esters homopolymer, homopolymers of acrylic acid alkyl esters or homopolymers of methacrylic acid alkyl esters; and other polymers having a hydroxyl group. Each of these binder resins may be used alone or in combination with two or more.

Examples of the alkyl group in the homopolymers of acrylic acid alkyl esters or the homopolymers of methacrylic acid alkyl esters include methyl groups, ethyl groups, normal-propyl groups, normal-butyl groups, isobutyl groups, normal-hexyl groups, cyclohexyl groups, and 2-ethyl hexyl groups.

Examples of the other polymers having a hydroxyl group include benzyl (meth)acrylate/ (homopolymer of methacrylic acid) acrylic acid copolymers, and benzyl (meth) acrylate/ (meth) acrylic acid /multi-component copolymers of other polymers.

The content of the binder resin is preferably 0% by mass to 80% by mass, and more preferably 0% by mass to 50% by mass to the total solid content of the cholesteric liquid crystal layer. When the content is more than 80% by mass, the orientation degree of the cholesteric liquid crystal layer may be insufficient.

The polymerization inhibitor is not particularly limited and may be suitably selected in accordance with the intended use, and examples thereof include hydroquinones, hydroquinone morio-metliyl ethers, phenothiazines, benzoquinones, or derivatives thereof.

The added amount of the polymerization inhibitor is preferably 0% by mass to 10% by mass, and more preferably 100 ppm to 1% by mass to the total solid content of the polymerizable monomer.

The solvent is not particularly limited and may be suitably selected from those known in the art. Examples thereof include alkoxy propionic acid esters such as 3-methoxy propionic acid methyl ester, 3-methoxy propionic acid ethyl ester, 3-methoxy propionic acid propyl ester, 3-ethoxy propionic acid methyl ester, 3-ethoxy propionic acid ethyl ester and 3-ethoxy propionic acid propyl ester; esters of alkoxy alcohols such as 2- methoxy propyl acetate, 2-ethoxy propyl acetate and 3-methoxy butyl acetate; lactic acid esters such as methyl lactate and ethyl lactate; ketones such as methyl ethyl ketone, cyclohexanon and methyl cyclohexanon; γ-butyrolactone, N-methyl pyrrolidone, di-methyl sulfoxide, chloroform and tetra-hydro furan. Each of these solvents may be used alone or in combination with two or more.

### < Base >

The base is not particularly limited as to its shape, structure, size and the like, and may be suitably selected in accordance with the intended use. For the shape of the base, plane and sheet shaped ones are exemplified. For the layer structure, a single layer structure or a multi-layered structure composed of two or more layers may be employed. The size of the base can be suitably selected in accordance with the size etc. of the wavelength selective reflection layer of the holographic recording medium.

Material of the base is not particularly limited, and both inorganic materials and organic materials can be preferably used.

Examples of the inorganic materials include glass, quartz, and silicon.

Examples of the organic materials include acetate resins such as triacetyl cellulose, polyester resins, polyether sulfone resins, polysulfone resins, polycarbonate resins, polyamide resins, polyimide resins, polyolefin resins, acryl resins, polynorbornene resins, cellulose resins, polyacrylate resins, polystyrene resins, polyvinyl alcohol resins, polyvinyl chloride resins, polyvinylidene chloride resins, and polyacrylate resins.

Each of these inorganic materials and organic materials may be used alone or in combination with two or more.

The base may be a suitably synthesized one or a commercially available product may be used.

The thickness of the base is not particularly limited and may be suitably adjusted in accordance with the intended use. The thickness is preferably 10µm to 500 µm, and more preferably 50 µm to 300 µm. When the thickness of the base is less than 10 µm, the adhesion property thereof may be degrade by bend of the base. In contrast, when the thickness is more than 500 µm, there is a need to substantially shift focal positions of information beam and reference beam, resulting in a large size optical system.

For the method of forming the wavelength selective reflection layer, for example, a coating solution for cholesteric liquid crystal layer prepared with the use of the solvent is applied over a surface of the base, and the applied coating solution is dried and irradiated with a ultraviolet ray to thereby a cholesteric liquid crystal layer can be formed.

As the most suitable forming method of the wavelength selective reflection layer, the base is prepared in a state of a roll, and a coating solution for cholesteric liquid crystal layer is applied over the surface of the rolled base by using a continuous type long coater like a bar coater, a die coater, a blade coater or a curtain coater.

Examples of the coating method include spin coating method, casting method, roller coating method, flow coating method, printing method, dip coating method, flow casting method, bar coating method, and gravure printing method.

The conditions for the irradiation with ultraviolet ray are not particularly limited and may be suitably selected in accordance with the intended use. For example, the wavelength of UV ray is preferably 160 nm to 380 nm, and more preferably 250 nm to 380 nm. The irradiation time is preferably, for example, 0.1 seconds to 600 seconds, and more preferably 0.3 seconds to 300 seconds. By adjusting conditions for irradiation with ultraviolet ray, the spiral pitch of the cholesteric liquid crystal layer can be continuously changed along the thickness direction of the liquid crystal layer.

In order to adjust the conditions for the irradiation with ultraviolet ray, a ultraviolet ray absorber can be added to the cholesteric liquid crystal layer. The ultraviolet ray absorber is not particularly limited and may be suitably selected in accordance with the intended use. Preferred examples thereof include benzophenone ultraviolet absorbers, benzotriazole ultraviolet absorbers, salicylic acid ultraviolet absorbers, cyanoacrylate ultraviolet absorbers, and oxalic acid anilide ultraviolet absorbers. Specific examples of these ultraviolet absorbers are described, for example, in Japanese Patent Application Laid-Open (JP-A) No. 47-10537, JP-A No. 58-111942, JP-A No. 58-212844, JP-A No. 59-19945, JP-A No. 59-46646, JP-A No. 59-109055, JP-A No. 63-53544, Japanese Patent Application Publication (JP-B) Nos. 36-10466, 42-26187,48-30492, 48-31255, 48-41572, 48-54965, 50-10726, US Patent No. 2,719,086, US Patent No. 3,707,375, US Patent No. 3,754,919, and US Patent No. 4,220,711.

The thickness of the cholesteric liquid crystal layer is preferably, for example, 1 µm to 10 µm, and more preferably 2 µm to 7 µm. When the thickness is less than 1 µm, the selective reflectance is not sufficient, and when the thickness is more than 10 µm, uniformity of the orientation of the liquid crystal may be distorted.

The cholesteric liquid crystal layer is preferably to be formed on the second substrate by applying a coating solution for cholesteric liquid crystal layer over a surface of the base, making the applied coating solution oriented, solidifying it, and subjecting it inclusive of the base to a process to be formed in a disc shape (for example, punching out process). When the cholesteric liquid crystal layer is used as a wavelength selective reflection layer of the holographic recording medium, it may also be directly formed on a second substrate, instead of forming it via a base. Specifically, the following methods are exemplified. Namely, (1) a method in which a coating solution for cholesteric liquid crystal is directly applied over a surface of a second substrate by spin-coating; and (2) a method in which a cholesteric liquid crystal layer is once formed on a base, the formed cholesteric liquid crystal layer is laminated on a second substrate, then only the base is peeled off from the second substrate, and the thus obtained cholesteric liquid crystal layer is bonded to the second substrate.

### [First Gap Layer]

The first gap layer is formed in between the wavelength selective reflection layer and the reflection surface in accordance with necessity, and is formed to smooth the surface of the second substrate. Formation of the first gap layer is effective in adjusting the size of a hologram formed in the holographic recording layer. In other words, it is effective that a gap is provided in between the recording layer and a servo pit pattern because an interference region formed with a reference beam and information beam for recording needs to be in a satisfactorily large size.

The first gap layer can be formed by applying a material such as a ultraviolet ray curable resin over the surface of the servo pit pattern by spin-coating, and hardening the material. When a layer formed by applying a ultraviolet ray curable resin on a transparent base is used as a wavelength selective reflection layer, the transparent base serves as the first gap layer.

The thickness of the first gap layer is not particularly limited and may be suitably adjusted in accordance with the intended use. The thickness of the first gap layer is preferably 1 µm to 200 µm.

### [Second Gap Layer]

The second gap layer is formed in between the recording layer and the wavelength selective reflection layer in accordance with the intended use.

The material of the second gap layer is not particularly limited and may be suitably selected in accordance with the intended use. Examples thereof include transparent resin films of tri-acetyl cellulose (TAC), polycarbonate (PC), polyethylene terephthalate (PET), polystyrene (PS), polysulfone (PSF), polyvinyl alcohol (PVA), polymethacrylic acid methyl-polymethyl methacrylate (PMMA), and the like; or norbornene resin film like product name: ARTON Film manufactured by JSR Corp. and ZEONOR manufactured by Zeon Corporation. Of these, materials having high isotropy are preferable. TAC, PC, product name: ARTON, and product name: ZEONOR are particularly preferable.

The thickness of the second gap layer is not particularly limited and may be suitably selected in accordance with the intended use. For example, it is preferably 1 µm to 200 µm.

Hereinafter, the holographic recording medium of the present invention will be described in detail with reference to drawings.

### < First Embodiment >

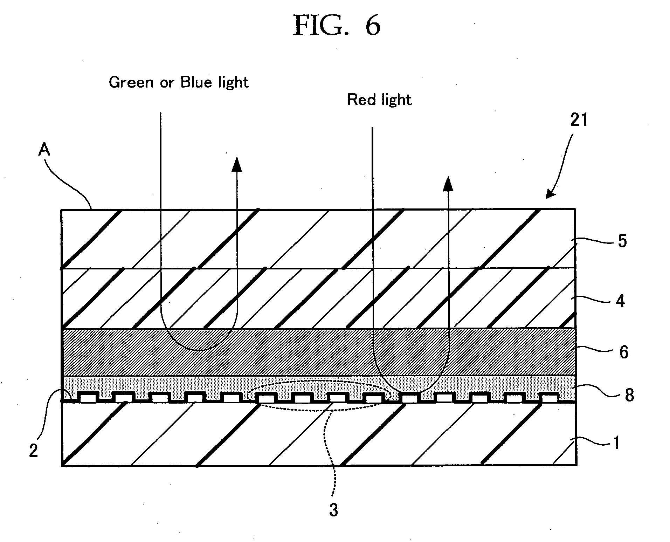

FIG. 6 is a schematic cross-sectional view of a structure of a holographic recording medium according to a first embodiment of the present invention. In the holographic recording medium 21 according to the first embodiment of the present invention, a servo pit pattern 3 is formed on a polycarbonate resin substrate or glass substrate 1, and a reflection surface 2 is formed on the servo pit pattern by coating the servo pit pattern surface with aluminum, gold, platinum or the like. In FIG. 6, the servo pit pattern is formed on the entire surface of a second substrate 1. The servo pit pattern 3 may be periodically formed as shown in FIG. 1. The height of the servo pit pattern 3 is typically 1750Å (175 nm) and is significantly thin as compared to the thickness of the other layers including the second substrate 1.

The first gap layer 8 is formed by applying a material such as a UV curable resin on the reflection surface 2 formed on the second substrate 1 by spin-coating, or the like. The first gap layer 8 is effective in adjusting the size of a hologram to be generated in a recording layer 4. In other words, since it is necessary to form an interference region formed with reference beam and information beam for recording in a satisfactorily large size, it is effective that a gap is provided in between the recording layer 4 and the servo pit pattern 3.

On a gap layer 8, a wavelength selective reflection layer 6 is formed, and a hologram recording medium 21 is structured by sandwiching the holographic recording layer 4 in between the wavelength selective reflection layer 6 and the first substrate 5 (polycarbonate resin substrate or glass substrate).

In FIG. 6, the wavelength selective reflection layer 6 transmits only red light, and does not transmit other color light beams. Thus, because the information beam and reference beam for recording and reproducing are green or blue lights, they are not transmissive to the wavelength selective reflection layer 6 and do not reach the reflection surface 2 to become returned light beams and be emitted from a light entering/ exiting surface A.

The wavelength selective reflection layer 6 is composed of a single layer of a cholesteric liquid crystal of which the spiral pitch is continuously changed in the thickness direction of the liquid crystal layer. The wavelength selective reflection layer 6 composed of the cholesteric liquid crystal layer may be directly formed on the first gap layer 8 by a coating method, or for the wavelength selective reflection layer 6, a film formed with a cholesteric liquid crystal layer thereon is punched out in a holographic recording medium shape, and the film is disposed on a substrate. The light reflectance in a wavelength range of λ₀ to λ₀/cos20°, in particular, in a wavelength range of λ₀ to λ₀/cos40° (λ₀ is a wavelength of light for irradiation) can be 40% or more without causing misalignment in selective reflective wavelength, even when the incident angle is changed, by effect of the single layer of the cholesteric liquid crystal layer of which the spiral pitch is continuously changed in the thickness direction of the liquid crystal layer.

The holographic recording medium 21 in the first embodiment may be formed in a disc shape or a card shape. When it is formed in a card shape, the servo pit pattern 3 is not necessarily provided. In the holographic recording medium 21, the second substrate 1 has a thickness of 0.6 mm, the first gap layer 8 has a thickness of 100 µm, the wavelength selective reflection layer 6 has a thickness of 2 µm to 3 µm, the holographic recording layer 4 has a thickness of 0.6 mm, and the first substrate 5 has a thickness of 0.6 mm, resulting in a total thickness of nearly 1.9 mm.

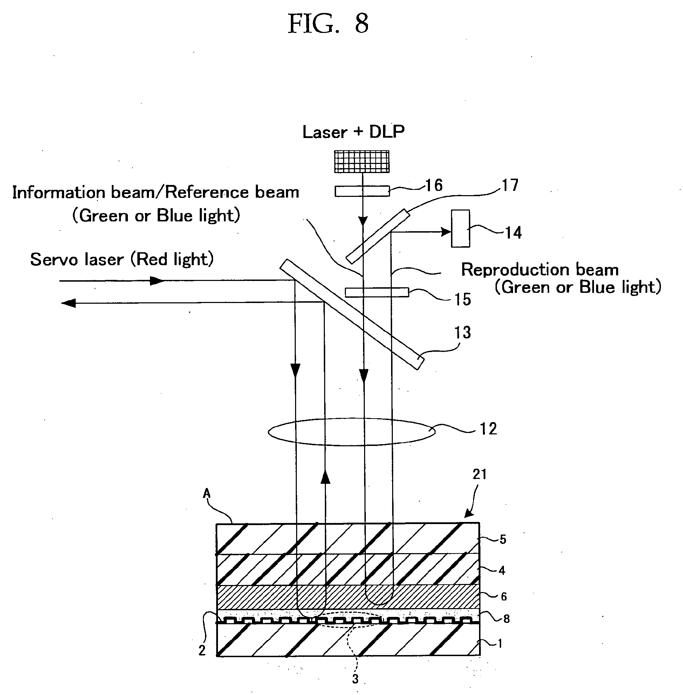

Next, optical operations of peripheral apparatuses disposed near the holographic recording medium 21 will be described with reference to FIG. 8. First, a servo light (red beam) is emitted from a servo laser, and it is reflected at 100 % by a dichroic mirror 13, and passes through an objective lens 12. The servo light is irradiated to the holographic recording medium 21 so as to be focused on the reflection layer 2 by the objective lens 12. In other words, the dichroic mirror 13 transmits green and blue wavelength lights, and reflects red wavelength light at almost 100 % . The servo light that is entered from a light entering/ exiting surface A of the holographic recording medium 21, passes through a first substrate 5, a holographic recording layer 4, a wavelength selective reflection layer 6, and a first gap layer 8, and then reflected by the reflection surface 2 and exits from the light entering/exiting surface A. Returned light that has exited from the light entering/exiting surface A passes through the objective lens 12 and is reflected by the dichroic mirror 13 at almost 100%, and the servo information is detected by a servo information detector (not shown in FIG. 8). The holographic material constituting the holographic recording layer 4 is not reactive to red light, and thus the holographic recording layer 4 is not affected by the servo light even when the servo light passes through the holographic recording layer 4 and reflects diffusely at the reflection surface 2. Further, returned light of the servo light at the reflection surface 2 are reflected by the dichroic mirror 13 at almost 100%, and thus the servo light is not detected by a CMOS sensor or CCD sensor 14 used for detecting reproduced images, resultantly, causing no noise is caused to reproduction light.

In the reflection range from λ₀ to 1.3λ₀ shown in FIG. 2, when λ₀ is equal to 532 nm, 1.3λ₀ is equal to 692nm and when the wavelength of the servo light is 655 nm, the servo light is reflected. The reflection region of λ₀ to 1.3λ₀ shown in FIG. 2 is suitable for an incident light applied at an angle of ±40° to the wavelength selective reflection layer, and when such a substantially inclined incident light is actually employed, the servo light can be controlled without any troubles by masking the servo light within the incident light angle of ± 20°. Further, it is easy to design all the incident light angles within the incident light angle of ±20° in a wavelength selective reflection layer to be used by sufficiently widening the spiral pitch of the cholesteric liquid crystal layer in the wavelength selective reflection layer. In this case, the cholesteric liquid crystal layer for wavelength of λ₀ to 1.1λ₀ as shown in FIG. 4 can be used, causing no problem with servo light transmission.

The information beam and reference beam for recording generated from a recording / reproducing laser pass through a deflection plate 16 to be linearly polarized light, and then the linearly polarized light passes through a half mirror 17 and, upon passing a quarter (1/4) wavelength plate 15, to be linearly polarized light beams. The information beam and the reference beam for recording pass through the dichroic mirror 13 and then are irradiated to the holographic recording medium 21 so that an interference pattern formed with the information beam and reference beam for recording is generated in the holographic recording layer 4 at the objective lens 12. The information beam and the reference beam for recording enter are entered from the light entering/ exiting surface A and interfere with each other on the holographic recording layer 4 to thereby generate an interference pattern on the holographic recording layer 4. Thereafter, the information beam and reference beam for recording pass through the holographic recording layer 4 and enter the wavelength selective reflection layer 6, however, reflected until they reach the bottom surface of the wavelength selective reflection layer 6 to be returned light. That is, the information beam and the reference beam for recording do not reach the reflection surface 2. The reason is that the wavelength selective reflection layer 6 is formed of a single layer of cholesteric liquid crystal layer of which the spiral pitch is continuously changed in the thickness direction of the liquid crystal layer, and has a characteristic that it transmits only red light. Alternatively, by keeping the optical energy of light that leaks from and passes through the wavelength selective reflection layer at 20% or less the light intensity of irradiation light, the light is reflected again at the wavelength selective reflection layer even when the leaked light reaches the bottom surface and is reflected there to be returned light. Therefore, the light intensity to be mixed in reproduction beam is 20% x 20% = 4% or less, and there is no problem virtually.

### < Second Embodiment >

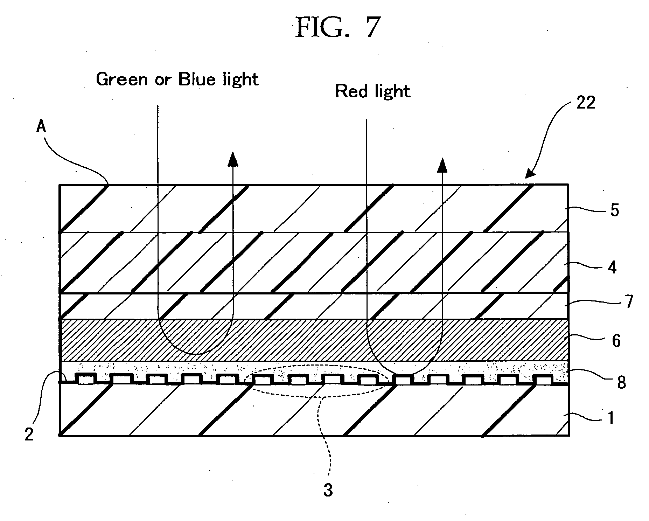

FIG. 7 is a schematic cross-sectional view of a structure of a holographic recording medium according to a second embodiment of the present invention. In the holographic recording medium 22 according to the second embodiment of the present invention, a servo pit pattern 3 is formed on a polycarbonate resin or a glass substrate 1, and a reflection surface 2 is formed by coating the servo pit pattern surface with aluminum, gold, platinum or the like. The height of the servo pit pattern 3 is as in the case with the first embodiment in that it is typically 1750 Å (175 nm).

A structural difference between the second embodiment and the first embodiment is that the holographic recording medium 22 according to the second embodiment has a second gap layer 7 formed in between a wavelength selective reflection layer 6 and a holographic recording layer 4.

After a first gap layer 8 is formed, the wavelength selective reflection layer 6 composed of a single layer of a cholesteric liquid crystal layer of which the spiral pitch is continuously changed in the thickness direction of the liquid crystal layer is formed on the first gap layer 8, and a wavelength selective reflection layer that is the same as in the first embodiment can be used.

In a second gap layer 7, there exists a point focused by an information beam and a reproduction beam. When this area is filled with photopolymer, the monomer is excessively consumed by excessive amount of exposure, resulting in degraded ability of multiple recording. To resolve the problem, it is effective that a second gap layer which is unreactive to light and is transparent is formed.

In the holographic recording medium 22, the second substrate 1 has a thickness of 1.0 mm, the first gap layer 8 has a thickness of 100 µm, the wavelength selective reflection layer 6 has a thickness of 3 µm to 5 µm, the second gap layer 7 has a thickness of 70 µm, the holographic recording layer 4 has a thickness of 0.6 mm, the first substrate 5 has a thickness of 0.4 mm, resulting a total thickness of nearly 2.2 mm.

When information is recorded or reproduced, the holographic recording medium 22 is irradiated with a red color servo light, a green color information beam, and a reference beam for recording and reproducing. The servo light enters the light entering/ exiting surface A, and passes through the holographic recording layer 4, the second gap layer 7, the wavelength selective reflection layer 6, and the first gap layer 8, and then is reflected at the reflection surface 2 to be returned light. The returned light passes through again the first gap layer 8, the wavelength selective reflection layer 6, the second gap layer 7, the holographic recording layer 4, and the first substrate 5 in this order, and then exits from the light entering/exiting surface A. The returned light is used for focus servo control, tracking servo control, and the like. A holographic material constituting the holographic recording layer 4 is not reactive to red light. Thus, even when the servo light passes through the holographic recording layer 4 and reflects diffusely at the reflection surface 2, the holographic recording layer 4 is not affected. Green color information beam and the like enter the light entering/ exiting surface A and pass through the holographic recording layer 4 and the second gap layer 7 and reflects at the wavelength selective reflection layer 6 to be returned light. The returned light passes through again the second gap layer 7, the holographic recording layer 4 and the first substrate 5 in this order and exits from the light entering/exiting surface A. Also in reproducing information, not only a reference beam for reproducing but also a reproduction beam that is generated by irradiating the holographic recording layer 4 exit from the light entering/ exiting surface A, without reaching the reflection surface 2. The optical operations of the peripheral apparatuses (the objective lens 12, the wavelength selective reflection layer 6, CMOS sensor or CCD sensor 14) disposed near the holographic recording medium 22 will be omitted because they are the same as those mentioned in the first embodiment (FIG. 8), and is not repeated here.

### (Method for Producing Holographic Recording Medium)

The method for producing a holographic recording medium of the present invention includes at least forming a holographic recording layer by depositing a composition for a holographic recording medium in between a first substrate and a second substrate, and further includes forming a wavelength selective reflection layer and forming a reflection layer, and other steps in accordance with necessity.

### < Holographic Recording layer forming step>

The holographic recording layer forming step is a step in which a holographic recording layer is formed by depositing a composition for a holographic recording medium in between a first substrate and a second substrate. The method of depositing the holographic recording layer in between a first substrate and a second substrate is already described in the description for the holographic recording layer.

### < Wavelength selective reflection layer forming step >

The wavelength selective reflection layer forming step is a step in which a wavelength selective reflection layer processed in the same shape of the holographic recording medium is bonded to the second substrate, and the forming method of the wavelength selective reflection layer is described as above.

### < Reflection layer forming step >

The reflection layer forming step is a step in which a reflection layer is formed on a servo pit pattern of a first substrate, and the forming method of the reflection layer is described as above.

The shape of the holographic recording medium is not particularly limited and may be suitably selected in accordance with the intended use. Examples of the shape include a disc shape and a card shape.

The shaping method is not particularly limited and may be suitably selected in accordance with the intended use, and examples there of include cutting by means of a press cutter, and punching by means of a punching cutter.

In the bonding process, for example, a filter is bonded to the substrate such that no air bubbles are induced therebetween using an adhesive, a pressure sensitive adhesive, or the like.

The adhesive is not particularly limited and may be suitably selected in accordance with the intended use. Examples thereof include various adhesives such as UV curable adhesive, emulsion type adhesive, one-component liquid curable adhesive and two-component liquid curable adhesive. Each conventionally known adhesives can be used in combination arbitrarily.

The pressure sensitive adhesive is not particularly limited and may be suitably selected in accordance with the intended use. Examples thereof include rubber pressure sensitive adhesive, acryl pressure sensitive adhesive, silicon pressure sensitive adhesive, urethane pressure sensitive adhesive, vinyl alkyl ether pressure sensitive adhesive, polyvinyl alcohol pressure sensitive adhesive, polyvinyl pyrrolidone pressure sensitive adhesive, poly acryl amide pressure sensitive adhesive, and cellulose pressure sensitive adhesive.

The thickness of the applied adhesive and pressure sensitive adhesive is not particularly limited and may be suitably adjusted in accordance with the intended use. In case of an adhesive, it is preferably 0.1 µm to 10 µm, and more preferably 0.1 µm to 5 µm from the perspective of optical properties and thinning of an optical recording medium. In case of a pressure sensitive adhesive, it is preferably 1 µm to 50µm, and more preferably 2 µm to 30 µm.

In some cases, the wavelength selective reflection layer can be directly formed on the substrate. For example, a method is exemplified in which a coating solution for cholesteric liquid crystal layer containing at least a nematic liquid crystal compound, a photoreactive chiral compound is applied over a surface of a substrate to thereby form a cholesteric liquid crystal layer.

The method for producing a holographic recording medium of the present invention enables to efficiently produce a holographic recording medium which allows for high density recording of holographic images and reproducing the recorded images with accuracy without causing transfer and polymerization of the monomer with lapse of time, because the holographic recording medium contains a compound which is reactive to polymerizable groups in the monomer by a stimulus from outside source.

### (Method for Recording Hologram and Method for Reproducing Hologram)

In the method for recording a holographic image of the present invention, the holographic recording medium of the present invention is irradiated with an information beam and a reference beam as a coaxial luminous flux, information is recorded on a recording layer based on an interference pattern formed by interference between the information beam and the reference beam, a stimulus from an outside source is applied to the holographic recording layer with the information recorded thereon, and the stimulus from the outside source makes a compound capable of reacting to polymerizable groups in a monomer reactive to the monomer.

In the method for reproducing a holographic image of the present invention, the interference pattern recorded on the holographic recording layer by the holographic recording method of the present invention is irradiated with a reference beam to thereby reproduce the recorded information.

In the holographic recording method and holographic reproducing method of the present invention, as described above, an information beam to which a two-dimensional distribution of light intensity is given and a reference beam having a substantially same light intensity as that of the information beam are overlapped in a photosensitive holographic recording layer to induce a distribution of optical properties in the holographic recording layer by utilizing an interference pattern formed by the information beam and the reference beam, thereby information can be recorded. When the recorded information is read (reproduced), the holographic recording layer is irradiated with only the reference beam in the same configuration as in the recording, and the reference beam exits from the holographic recording layer as a reproduction beam having a light intensity distribution corresponding to an optical property distribution formed in the holographic recording layer.

### < Recording and Reproducing of holographic image >

For the holographic recording method, holographic reproducing method for the holographic recording medium of the present invention and a holographic recording and reproducing apparatus used for the holographic recording medium of the present invention, various proposed methods and holographic recording and reproducing apparatuses can be suitably selected from among conventionally proposed methods and apparatuses, provided that holograms can be holographically record and recorded and reproduced on the holographic recording medium of the present invention by them. Examples of such holographic recording and holographic reproducing method and such a holographic recording and reproducing apparatus include those disclosed in US Patent No. 5,719,691, US Patent No. 5,838,467, US Patent No. 6,163,391, US Patent No. 6,414,296, US Patent Serial No. 2002-136143, Japanese Patent Application Laid-Open (JP-A) No. 9-305978, JP-A No. 10-124872, JP-A No. 11-219540, JP-A No. 2000-98862, JP-A No. 2000-298837, JP-A No. 2001-23169, JP-A No. 2002-83431, JP-A No. 2002-123949, JP-A No, 2002-123948, JP-A No. 2003-43904, JP-A No. 2004-171611, International Publication No. WO99/57719, International Publication No. WO02/05270, and International Publication No. WO02/75727. As for a laser source used in the holographic recording and reproducing methods and the holographic recording and reproducing apparatuses mentioned above, there is no particular limitation on the laser source and various laser sources may be used as long as it is a laser source that can activate a photopolymerization initiator in the recording medium, holographically record information, and read the recorded holographic information. Examples of such a laser source include blue ray-semiconductor lasers, argon lasers, He-Cd lasers, frequency doubled YAG lasers, He-Ne lasers, Kr lasers, near infrared ray semiconductor lasers.

### < Fixing of Holographic Image >

The composition for a holographic recording medium can be fixed. The term "fixing" means that a holographic recording layer, in which information has been holographically recorded, is irradiated with light, thereby a photopolymerization initiator in the composition for a holographic recording medium is photodegraded to take away the polymerization initiating ability thereof. It is necessary that the holographic recording layer be irradiated under moderate irradiation conditions so as not to damage a holographic image by the fixing step.

The entire surface of the holographic recording layer may be irradiated or the holographic recording layer may be irradiated in a linear pattern or in a dot pattern.

For a light source used in the fixing, it is preferable to use an incoherent light. Preferred examples of such a light source include fluorescent lamps, high pressure mercury lamps, xenon lamps, and light emitting diodes. The energy intensity of the light sources is preferably less than 1 J/cm², and more preferably less than 300 mJ/cm². When the energy intensity is more than 1J/cm², the holographic image may be sometimes damaged.

Here, the method of holographic recording and the method of holographic reproducing of the present invention, specifically, are carried out by, for example, using a holographic recording and reproducing apparatus of the present invention.

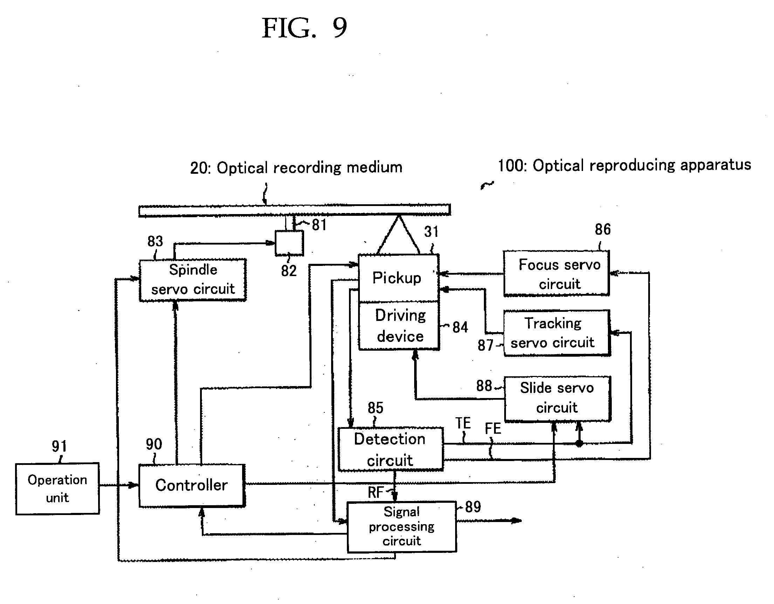

The holographic recording and reproducing apparatus used in the method of holographic recording and method of holographic reproducing of the present invention will be described with reference to FIG. 9.

FIG. 9 is a block diagram showing one example of the total configuration of an optical recording and reproducing apparatus of the present invention. It should be noted that the optical recording and reproducing apparatus is equipped with a holographic recording apparatus and a holographic reproducing apparatus.

A holographic recording and reproducing apparatus 100 is provided with a spindle 81 to which a holographic recording medium 20 is attached, a spindle motor 82 that rotates the spindle 81, a spindle servo circuit 83 that controls the spindle motor 82 so as to keep the number of revolutions of the holographic recording medium 20 at a specific rate.

Further, the holographic recording and reproducing apparatus 100 is equipped with a pickup 31 to irradiate the holographic recording medium 20 with an information beam and a recording reference beam to thereby record information, and to irradiate the holographic recording medium 20 with a reference beam for reproducing to detect reproduction beam to thereby reproduce the information recorded in the holographic recording medium 20; and a driving unit 84 capable of moving in the radius direction of the holographic recording medium 20.

The holographic recording and reproducing apparatus 100 is equipped with a detection circuit 85 which detects focus error signal FE, tracking error signal TE, and reproduced signal RF based on output signal from the pickup 31; a focus servo circuit 86 to perform focus servo control by driving an actuator in the pickup 31 based on the focus error signal FE detected by the detection circuit 85 to move an objective lens (not shown) in the thickness direction of the holographic recording medium 20; a tracking servo circuit 87 to perform tracking servo control by driving the actuator in the pickup 31 based on the tracking error signal TE detected by the detection circuit 85 to move the objective lens in the radius direction of the holographic recording medium 20; and a slide servo circuit 88 to perform slide servo control by control the driving unit 84 based on a command from the tracking error signal TE and a controller to be hereinafter described to move the pickup 31 in the radium direction of the holographic recording medium 20.

The holographic recording and reproducing apparatus 100 is further equipped with a signal processing circuit 89 which decodes an output signal from a CMOS or CCD array in the pickup 31 to regenerate data recorded in a data area of the holographic recording medium 20, to regenerate a base clock signal based on a reproduction signal RF from the detection circuit 85 and to distinguish address information; a controller 90 to control all the operations of the holographic recording and reproducing apparatus 100; and an operation unit 91 to give various instructions to the controller 90.

The controller 90 is configured to input the base clock signal and the address information output from the signal processing circuit 89 as,well as to control the pickup 31, a spindle servo circuit 83, the slide servo circuit 88, and the like. The spindle servo circuit 83 is configured to input the base clock signal output from the signal processing circuit 89. The controller 90 has CPU (Center Processing Unit), ROM (Read Only Memory), and RAM (Random Access memory), and CPU executes a program stored in ROM using RAM as a working area to thereby realize all the functions of the controller 90.

Since the holographic recording and reproducing apparatus used in the holographic recording method and holographic reproducing method in the present invention uses the holographic recording medium of the present invention, the holographic recording and reproducing apparatus can prevent diffused reflection of information beams and reference beams from the reflection surface of the holographic recording medium and prevent occurrence of noise without causing misalignment of selective reflection wavelength even when the incident angle is changed and can realize high density recording that has not been conventionally provided so far.

### EXAMPLES

Hereafter, the present invention will be further described in detail referring to specific Examples and Comparative Examples, however, the present invention is not limited to the disclosed Examples.

### (Example 1)

### < Preparation of Composition for Holographic Recording Medium >

By use of the following composition, a polymerizable monomer and a photopolymerization initiator were mixed or dissolved, and then a polymer compound serving as a binder was further added thereto, and the solvent liquid was stirred at room temperature. The polymer compound was dissolved or swelled in the solvent liquid. The polymer that could not be dissolved in the solvent liquid was stirred in swelled condition for 24 hours at room temperature to impregnate the inside of the swelled polymer pellets with the polymerizable monomer and photopolymerization initiator until saturation. And the solvent liquid was placed in an evaporator to vaporize the solvent under low pressure, and after that the liquid was dried under the condition of temperature of 40°C, low pressure, and duration time of 24 hours. The obtained composition was pulverized to thereby obtain a composition for a holographic recording medium in a state of pellet.

### [Composition]

- Solvent (Tetrahydrofuran) --- 40.0 parts by mass
- Monomer : EO-modified tribromophenyl acrylate (manufactured by Dai-Ichi Kogyo Seiyaku Co., Ltd., NEW FRONTIER BR-31) --- 0.47 parts by mass
- Photo Polymerization Initiator: IRGACURE 784 (manufactured by Chiba Specialty Chemicals K.K.) - 0.087 parts by mass
- Polymer : P1 (see Table 1) --- 4.49 parts by mass

As for the polymer, when the polymer was immersed in the solvent, it was swelled, however, was not dissolved, and also micro-crystal regions of polyethylene were found by X-ray diffraction, and thereby it was concluded that a three-dimensional crosslinking structure was formed in the polymer.

### < Production of Holographic Recording Medium >

As for a second substrate, a typical polycarbonate resin substrate having a diameter of 120 mm and a thickness of 0.6 mm used for DVD+RW was used. On the entire surface of the substrate, a servo pit pattern was formed with a track pitch of 0.74 µm, a groove depth of 175 nm, and a groove width of 300 nm.

First, a reflection layer was formed on the servo pit pattern of the second substrate. As a reflection material, aluminum (Al) was used. An aluminum thin film having a thickness of 200 nm serving as the reflection layer was formed by DC magnetron spattering method.

And then, SD-640 (Dainippon Ink and Chemicals) was used for a protection layer so as to be 50 µm thickness over the surface of the reflection layer by spin coating. On the protection layer, TiO₂ and SiO₂ were alternatively evaporated up to eleven layers in total to thereby form a wavelength selective film of λ/4 thickness.

The composition for a holographic recording medium in a state of pellet was piled on the second substrate, and the first substrate of polycarbonate resin of 120 mm diameter and 0.6 mm thickness was pushed on the composition for a holographic recording medium, and by so called hot press method, the composition for a holographic recording medium was sandwiched in between the first substrate and the second substrate to form a holographic recording layer as well as bond the second substrate with the first substrate. At the edge of the second substrate, a cylindrical flange was provided such that the thickness of the holographic recording layer was 500 µm, and the thickness of the holographic recording layer was determined by bonding the first substrate with the flange. The bonded first substrate and second substrate was left under the condition of a temperature of 40 °C for 24 hours for cooling, thereby a holographic recording medium was produced. FIG. 6 is a schematic cross-sectional view of a holographic recording medium which was based on an embodiment similar to that of Example 1. In the embodiment shown in FIG. 6, the holographic recording medium was produced without forming a wavelength selective reflection layer and a second gap layer.

### < Evaluation of Planarity >

For the obtained holographic recording medium, visual inspection was done based on the following evaluation criteria. The result was shown in Table 3.
A: There was no crack, dent, bulge in the holographic recording layer, and no influence was found on holographic recording in the entire surface of the disc.
B: There were some dents found in the first substrate of the holographic recording layer, however, no dent was found in the second substrate, and holographic recording was affected depending on the recorded area of the disc.
C: There were some dents found in the holographic recording layer, and holographic recording was affected in the almost entire surface of the disc.

### < Holographic Recording to Holographic Recording Layer and Evaluation >

For the thus produced holographic recording media, recording sensitivity (necessary recording energy) and the number of times of possible multiple recording were measured by using a co-linear holographic recording and reproducing tester, SHOT-1000, manufactured by Pulstec Industrial Co. under the condition of writing a series of multiple holograms in recording spot size of diameter: 200 µm at the focus point of the holographic recording.

### (Measurement of Sensitivity)

With changing the optical energy of irradiation light (mJ/cm²) at holographic recording, bit error rate (BER) of reproduced signals was measured. Usually, there is a tendency that an increased optical energy of the irradiation light gives an increased luminance of the reproduced signal and the bit error rate (BER) was gradually decreased. The recording sensitivity of the holographic recording medium was defined as the lowest optical energy of irradiation which was needed to obtain an excellently reproduced image and was equivalent to the bit error rate (BER < 10⁻³).

### (Evaluation of Number of Times of Possible Multiple Recording)

As a method of evaluation on the number of times of possible multiple recording, a method described in ISOM'04, Th-J-06, pp. 184 - 185, Oct. 2004, was used, in which a recording light spot was spirally shifted on a holographic recording medium, where the number of recorded holograms was 13 x 13 = 169, the recording pitch was set to 28.5 µm. The number of times of possible multiple recording at the last 169-th holographic recording was 49.

The number of times of possible multiple recording increases in accordance with the number of the recorded holograms, and thus if the multiple recording property of the holographic recording medium was insufficient, the BER increases in accordance with the number of recording. Here, the number of recorded holograms obtained when the BER is more than 10⁻³, was defined as multiple recording property M of the holographic recording medium.

### (Examples 2 to 9)

### < Production of Holographic Recording Medium >

Compositions for holographic recording media were prepared in the same manner as in Example 1, except that the polymer in the composition for a holographic recording medium was changed to polymers P-2 to P-9 shown in Table 1, thereby holographic recording media of Examples 2 to 9 were produced.

As for the polymers, formation of a three-dimensional crosslinking structure in each polymer was confirmed similarly to that of Example 1. As for polymers which do not make salt and polymers which do not have Zn, they were dissolved in the solvent of tetrahydrofuran, and formation of a three-dimensional crosslinking structure was checked depending on presence or absence of microscopic crystal regions identified by X-ray diffraction.

The obtained holographic recording media were evaluated as to planarity in the same manner as in Example 1, and information was holographically recorded on the respective holographic recording media to evaluate them as to sensitivity and the number of possible multiple recording. The results were shown in Table 3.

**Table1**

| | Polymer |
|---|---|
| Example 1 | P-1 |
| Example 2 | P-2 |
| Example 3 | P-3 |
| Example 4 | P-4 |
| Example 5 | P-5 |
| Example 6 | P-6 |
| Example 7 | P-7 |
| Example 8 | P-8 |
| Example 9 | P-9 |

In Table 1, the formal names of polymers P-1 to P-9 were as follows:
P-1 : zinc salt of ethylene-methacrylate copolymer (methacrylic acid of 15% by mass, melting point of 73 °C, softening point of 61 °C, melt viscosity of 14g/10min: manufactured by Aldrich, 426660).
P-2 : ethylene-methacrylate copolymer (methacrylic acid of 15% by mass, melting point of 76 °C, softening point of 62 °C, melt viscosity of 60 g/10 min : manufactured by Aldrich, 426628).
P-3 : sodium salt of ethylene-methacrylate copolymer (melting point of 81°C to 96 °C, softening point of 63 °C, melt viscosity of 3.9 g/10 min : manufactured by Aldrich, 426695).
P-4 : HIMILAN 1706 (ion type of Zn, melting point of 88 °C, softening point of 65 °C, melt viscosity of 0.9 g/10 min : manufactured by DuPont-Mitsui Polychemicals Co., Ltd.).
P-5 : HIMILAN 1707 (ion type of Na, melting point of 89 °C, softening point of 60 °C, melt viscosity of 0.9 g/10 min : manufactured by DuPont-Mitsui Polychemicals Co., Ltd.).
P-6 : HIMILAN 1605 (ion type of Na, melting point of 92 °C, softening point of 66 °C, melt viscosity of 2.8 g/10 min : manufactured by DuPont-Mitsui Polychemicals).
P-7 : zinc salt of ethylene - acrylic acid (acrylic acid of 5% by mass, melting point of 99 °C : manufactured by Aldrich, 426768).
P-8 : ethylene - acrylic acid copolymer (acrylic acid of 15% by mass, melting point of 87°C : manufactured by Aldrich, 448672).
P-9 : ethylene-vinyl acetate copolymer (vinyl acetate of 18% by mass, melt viscosity of 7.5 g/10 min : manufactured by Aldrich, 181056).

### (Example 10)

### < Preparation of Holographic recording Medium Material >

By use of the following composition, a polymerizable monomer and a photopolymerization initiator were mixed or dissolved, and then a polymer compound serving as a binder was further added thereto, and the solvent liquid was stirred at room temperature.

The solvent liquid was applied on a substrate and dried for the finished dry thickness of 500 µm, then cast in a proper shape to thereby obtain a film of a composition for a holographic recording medium.

### [Composition]

- Solvent (Tetrahydrofuran) --- 40.0 parts by mass
- Monomer : EO-modified tribromophenyl acrylate (NEW FRONTIER BR-31, manufactured by Dai-Ichi Kogyo Seiyaku Co., Ltd.) - 0.47 parts by mass
- Photo Polymerization Initiator : IRGACURE 784 (manufactured by Chiba Specialty Chemicals K.K.) --- 0.087 parts by mass
- Polymer : 20% by mass solution of NAFION (663492 manufactured by Aldrich) --- 22.45 parts by mass

Existence of a three-dimensional crosslinking structure was confirmed by the same way of identification as in the case of Example 1.

### < Production of Holographic Recording Medium >

After punching the obtained film of the composition for a holographic recording medium in a shape of doughnut so as to be sandwiched in between the first substrate and the second substrate, the punched film was placed on the second substrate and then the first substrate was placed on the punched film to bond them together by hot press method, thereby a holographic recording medium was produced.

The obtained holographic recording medium was evaluated as to planarity in the same manner as in Example 1, and information was holographically recorded on the holographic recording medium to evaluate it as to sensitivity and the number of possible multiple recording. The results were shown in Table 3.

### (Example 11)

A holographic recording medium was produced using the same composition for a holographic recording medium used in Example 1, except that a wavelength selective reflection layer was formed on the second substrate. The wavelength selective reflection layer was formed as follows.

### < Production of Holographic Recording Medium >

### - Preparation of Wave Length Selective Reflection Layer -

First, polyvinyl alcohol (MP203, manufactured by KURARAY Co., Ltd.) was coated with 1 µm in thickness on a polycarbonate film (UPIRON, manufactured by MITSUBISHI GAS CHEMICAL CO., INC.) of 100 µm in thickness to prepare a base. The base was set in and passed through a rubbing device to rub the polyvinyl alcohol layer surface of the base and give liquid crystal orientation property thereto.

Next, a coating solution for cholesteric liquid crystal layer containing the composition shown in Table 2 was prepared by a conventional method.

**Table 2**

| Component (part by mass) | Coating solution for cholesteric liquid crystal layer |
|---|---|
| UV Polymerization Liquid Crystal | 94.74 |
| Photo Reactive Chiral Compound | 6.50 |
| Photo Polymerization Initiator | 0.10 |
| Sensitizer | 0.02 |
| Solvent | 400 |

| | |
|---|---|
| * UV polymerizable liquid crystal: PALIOLOLOR LC242, manufactured by BASF Corporation. * Photo reactive chiral compound : photoreactive isosorbide derivative expressed by the following formula. 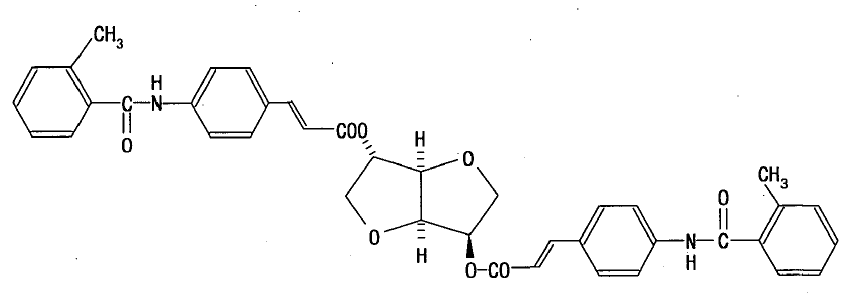 * Photo polymerization initiator : IRGACURE 369, manufactured by Chiba Specialty Chemicals K.K. * Sensitizer : diethyl thioxanthone * Solvent: methyl ethyl ketone (MEK) | |

Subsequently, over a surface of the base, the coating solution for cholesteric liquid crystal layer was applied by a bar coater, and the base surface was dried and then the orientation was aged at a temperature of 110°C for 20 seconds. The base surface was irradiated with an ultra high pressure mercury lamp for 1 minute via a band pass filter having a light source with a center wavelength of 365 nm under the condition of 110°C. Thereafter, the base was kept in a dark chamber in a state where the temperature was kept at 110°C for five minutes. Then, the band pass filter was removed, and the entire surface of the base was exposed by use of the same ultra high pressure mercury lamp with the exposure light energy of 500 mJ/cm² with spraying a nitrogen gas to polymerize and harden the base surface, thereby a hardened film of a cholesteric liquid crystal layer was formed.

By the above process, a wavelength selective reflection layer was prepared.

The light reflection property of the produced wavelength selective reflection layer was measured using a reflection spectroscope (light source: L-5662, manufactured by Hamamatsu Photonics, photo multi-channel analyzer: PMA-11 manufactured by Hamamatsu Photonics).

As a result, it was confirmed that the filter could reflect having a selective wavelength of 532 nm 40 % or more to the light within an incident angle of 20°C as shown in FIGS. 4 and 5. And the band width of the selective reflection wavelength was of a wide value of 180 nm.

As in the case of Example 1, first, aluminum reflection layer was formed on the surface of the servo pit pattern of the second substrate of polycarbonate resin having a diameter of 120 mm and a thickness of 0.6 mm.

Next, the wavelength reflection layer was punched in a predetermined disc size so as to fit the second substrate, and the wavelength reflection layer was bonded to the second substrate such that the base surface faced to the servo pit pattern side of the second substrate using a UV curable resin or a pressure sensitive adhesive, with no air bubbles included therein.

Thereafter, using the composition for a holographic recording medium 1 prepared in Example 1, and according to the same production method as in Example 1, a holographic recording layer was formed between the second substrate having the wavelength selective reflection layer and the first substrate. By the above process, a holographic recording medium was produced. FIG. 6 is a schematic cross-sectional view of a holographic recording medium based on a similar embodiment to Example 11.

The obtained holographic recording medium was evaluated as to planarity in the same manner as in Example 1, and information was holographically recorded on the holographic recording medium to evaluate it as to sensitivity and the number of possible multiple recording. The results were shown in Table 3.

### (Example 12)

### < Production of Holographic Recording Medium >

A holographic recording medium was produced in the same manner as in Example 11, except that a second gap layer was formed between the reflection layer and the wavelength selective reflection layer. As for the second gap layer, a polycarbonate film having a thickness of 100 µm was used, and the second gap layer was bonded therebetween using a UV curable resin. FIG. 7 is a schematic cross-sectional view of a holographic recording medium based on a similar embodiment to Example 12.

The obtained holographic recording medium of Example 12 was evaluated as to planarity in the same manner as in Example 1, and information was holographically recorded on the holographic recording medium to evaluate it as to sensitivity and the number of possible multiple recording. The results were shown in Table 3.

### (Comparative Example 1)

### < Production of Holographic Recording Medium >

A composition for a holographic recording medium was prepared in the same manner as in Example 1, except that the polymer in the composition for a holographic recording medium was changed to polybutyl methacrylate (mass average molecular mass of 320,000, the number average molecular mass of 73,500, glass transition temperature (Tg) of 15 °C), thereby a holographic recording medium was produced.

The obtained holographic recording medium of Example 12 was evaluated as to planarity in the same manner as in Example 1, and information was holographically recorded on the holographic recording medium to evaluate it as to sensitivity and the number of possible multiple recording. The results were shown in Table 3. Note that with the holographic recording medium of Comparative Example 1, the recorded hologram was degraded with the lapse of time, and the number of possible multiple recording was limited to three.

### (Comparative Example 2)

### < Preparation of Composition for Holographic Recording Medium >

Using the following composition, the respective components were mixed in dry air stream to yield a composition for a holographic recording medium.

### [Composition]

- Bis-cyclohexylmethane diisocyanate --- 31.5 parts by mass
- Polypropylene oxide triol (mass average molecular mass of 1,000) --- 61.2 parts by mass
- Tetramethylene glycol --- 2.5 parts by mass
- Monomer : EO-modified tribromophenyl acrylate (NEW FRONTIER BR-31, manufactured by Dai-Ichi Kogyo Seiyaku Co., Ltd.) --- 9.52 parts by mass
- Tin dibutyl laurate ---1.01 parts by mass
- Photo Polymerization Initiator : IRGACURE 784 (manufactured by Chiba Specialty Chemicals K.K.) ---1.76 parts by mass

### < Production of Holographic Recording Medium >

As in the case of Example 1, a second substrate was prepared. Then, the second substrate was heated at 70 °C, and the composition for a holographic recording medium were piled on a surface of the second substrate using a dispenser, thereby holographic recording layer was formed. On the holographic recording layer, a first substrate of polycarbonate resin of 120 mm diameter and 0.6 mm thickness was pressed to sandwich the holographic recording layer in between the first substrate and second substrate, and then the edge of the second substrate and the first substrate were bonded together using an adhesive. The bonded first substrate and second substrate was left under the condition of a temperature of 40 °C for 24 hours for cooling, thereby a holographic recording medium was produced.

The obtained holographic recording medium was evaluated as to planarity in the same manner as in Example 1, and information was holographically recorded on the holographic recording medium to evaluate it as to sensitivity and the number of possible multiple recording. The results were shown in Table 3. Note that in Comparative Example 2, a urethane matrix was used as a binder, and the holographic recording layer shrank in volume at curing, and because of the shrinkage, dents were found in the first substrate and the planarity thereof was degraded, and it was found that holographic recording was impossible or the multiple recording property was degraded depending on the recorded area of the disc.

**Table 3**

| | Planarity | Exposure sensitivity (mJ/cm²) | Number of times of possible multiple recording |
|---|---|---|---|
| Ex. 1 | A | 20.0 | 35 |
| Ex. 2 | A | 20.0 | 30 |
| Ex. 3 | A | 20.0 | 33 |
| Ex. 4 | A | 20.0 | 35 |
| Ex. 5 | A | 20.0 | 34 |
| Ex .6 | A | 20.0 | 33 |
| Ex. 7 | A | 20.0 | 34 |
| Ex. 8 | A | 20.0 | 31 |
| Ex. 9 | A | 20.0 | 30 |
| Ex. 10 | A | 20.0 | 35 |
| Ex. 11 | A | 20.0 | 35 |
| Ex. 12 | A | 20.0 | 35 |
| Compara. Ex. 1 | A | 100 | 3 |
| Compara. Ex. 2 | B | 20.0 | 35 |

Based on the results shown in Table 3, it was found that the holographic recording media of Examples 1 to 12 each formed from a composition for a holographic recording medium using a polymer as a binder in which a three-dimensional crosslinking structure was formed by non-polymerization reaction were respectively excellent in planarity and had high recording sensitivity to allow high density recording and reproducing of recorded high-density information.

The present invention can provide a composition for a holographic recording medium that can solve various conventional problems and allow for producing a disc medium filled with a photopolymer by a very simple method such as hot press method, with high dimensional precision, high uniformity and high productivity, a holographic recording medium using the composition for a holographic recording medium allowing for high-density recording, and a method for producing the holographic recording medium.

The composition for a holographic recording medium of the present invention is preferably used for volume holographic recording media, since the composition for a holographic recording medium allows for producing a disc medium filled with a photopolymer by a very simple method such as hot press method, with high dimensional precision, high uniformity and high productivity. Thus, the composition for a holographic recording medium allows for high-density recording of images and reproduction of the high-density recorded information by reading recorded holographic images with accuracy.

The holographic recording medium of the present invention is widely used for various volume holographic recording media, since the holographic recording medium allows for recording high-density recording of images at high sensitivity by preventing occurrences of noise and without substantially causing misalignment in selective reflection wavelength even when the incident light angle is changed, and allows for reading recorded holographic images with accuracy to reproduce the high density recorded information.

## Claims

1. A composition for a holographic recording medium, comprising:
a binder,
a polymerizable polymer, and
a photopolymerization initiator,
wherein the binder is a polymer capable of forming a three-dimensional crosslinking structure by non-polymerization reaction.

2. The composition for a holographic recording medium according to claim 1, wherein the polymer capable of forming a three-dimensional crosslinking structure by non-polymerization reaction is at least one of (A) a polymer which has an ionic group and formed a salt with the counterion of the ionic group and (B) a polymer having a crystal structure.

3. The composition for a holographic recording medium according to claim 2, wherein (A) the polymer which has an ionic group and formed a salt with the counterion of the ionic group is an ionomer resin.

4. The composition for a holographic recording medium according to claim 3, wherein the ionomer resin is an ethylene ionomer resin.

5. The composition for a holographic recording medium according to any one of claims 2 to 4, wherein (B) the polymer having a crystal structure is an ethylene copolymer resin.

6. The composition for a holographic recording medium according to claim 5, wherein the ethylene copolymer resin is any one of an ethylene-carboxylic acid copolymer resin and an ethylene-vinyl acetate copolymer resin.

7. A holographic recording medium, comprising:
a substrate,
a holographic recording layer containing a composition for a holographic recording medium according to any one of claims 1 to 6, and
a wavelength selective reflection layer formed in between the substrate and the holographic recording layer.

8. The holographic recording medium according to claim 7, wherein the substrate has a servo pit pattern.

9. The holographic recording medium according to claim 8, wherein the substrate further has a reflection surface on the surface of the servo pit pattern.

10. The holographic recording medium according to any one of claims 7 to 9, wherein the wavelength selective reflection layer is a layer containing a dichroic mirror.

11. The holographic recording medium according to any one of claims 7 to 9, wherein the wavelength selective reflection layer is a layer containing a cholesteric liquid crystal.

12. The holographic recording medium according to any one of claims 9 to 11, further comprising a gap layer formed in between the wavelength selective reflection layer and the reflection surface, to smooth the substrate surface.

13. A method for producing a holographic recording medium, comprising:
forming a holographic recording layer using a composition for a holographic recording medium according to any one of claims 1 to 6,
wherein the holographic recording medium comprises a substrate, the holographic recording layer in which information is holographically recorded, and a wavelength reflection layer formed between the substrate and the holographic recording layer.
